# EUROPEAN PATENT APPLICATION

(11) **EP 4 586 046 A1**
(43) Date of publication of application: **16.07.2025**
(21) Application number: 23863532.0
(22) Date of filing: 07.09.2023
(51) Int. Cl.: G06F 1/16, H04M 1/02, F16C 11/04

(54) **HINGE MODULE AND ELECTRONIC DEVICE COMPRISING SAME**

(30) Priority: 07.09.2022 KR 20220113303; 26.09.2022 KR 20220121994
(71) Applicant: Samsung Electronics Co., Ltd., Suwon-si, Gyeonggi-do 16677 (KR)
(72) Inventor: CHOI, Soobin, Suwon-si Gyeonggi-do 16677 (KR); KIM, Jongkeun, Suwon-si Gyeonggi-do 16677 (KR)
(74) Representative: Nederlandsch Octrooibureau
(86) International application number: PCT/KR2023/013433
(87) International publication number: WO 2024/054068

(57) **Abstract**

An embodiment of the present disclosure may provide an electronic device comprising a hinge module. The electronic device may comprise a hinge module including: a rotating member connected to a housing; a first arm member having one end including a first cam structure and the other end having a first protrusion formed therefrom; a second arm member having one end including a second cam structure and the other end having a second protrusion formed therefrom; and a guide member connected to the rotating member and having a first surface having a first rail in which the first protrusion of the first arm member is accommodated, and a second surface having a second rail in which the second protrusion of the second arm member is accommodated. **In** addition, various embodiments may be applied.

## Description

### [Technical Field]

Various embodiments of the disclosure relate to an electronic device, e.g., a hinge module and/or an electronic device including the same.

### [Background Art]

The growth of electronics, information, and communication technologies leads to integration of various functions into a single electronic device. For example, smartphones pack the functionalities of a sound player, imaging device, and scheduler, as well as the communication functionality and, on top of that, may implement more various functions by having applications installed thereon.

As smartphones or other personal/portable electronic devices spread, users' demand for portability and use convenience is on the rise. For example, a touchscreen display may not only serve as an output device of visual information but also provide a virtual keyboard that replaces a physical input device (e.g., a keypad). To provide enhanced usability (e.g., larger screens), electronic devices including flexible, e.g., foldable or rollable displays have been commercially available.

Foldable electronic devices may include a free stop function to increase user convenience. Free stop may be to allow the housing of a foldable electronic device to stop at a certain angle when the user folds or unfolds the housing. If the electronic device includes a free stop function, it may allow the user to perform actions, such as viewing photos and/or videos, or photographing and/or editing photos, more conveniently even when the housing is in a partially folded state (e.g., an intermediate state).

For example, the user may perform an action of directly unfolding or folding the foldable electronic device using her body part (e.g., a hand), and may take a photo or watch a video using the free stop function in the partially folded state (e.g., an intermediate state) of the electronic device. When the user uses both hands, it may be easy to unfold or fold the foldable electronic device, but when the user uses one hand, it may not be easy to unfold or fold the foldable electronic device. The hinge module of the foldable electronic device may be configured so that the foldable electronic device is unfolded or folded when a torque larger than or equal to the elastic repulsive force of the elastic member (e.g., a spring) or more included in the hinge module acts in some sections, and the free stop function may be implemented to be activated when the foldable electronic device is folded at a designated angle or within a designated angle range. For example, the free stop function may be configured to be implemented when the first housing and the second housing of the foldable electronic device is unfolded at an angle between about 60 degrees to 120 degrees. However, when the user unfolds or folds the electronic device (e.g., when unfolding or folding the electronic device with only one hand), if the free stop function is implemented, it may be difficult to fully unfold or fold the electronic device. The free stop function may provide convenience when taking a photo and/or watching video or photographing and/or editing in the stopped state, but may cause inconvenience when the user unfolds or folds the electronic device. If the angle at which the free stop function is implemented is reduced in design to reduce the inconvenience in unfolding or folding the foldable electronic device with one hand, it may restrict use of the free stop function.

Such an issue may come from the fact that the foldable electronic device is designed so that the section where the free stop function of the foldable electronic device may be implemented is fixed to a specific angle or an angle range. The disclosure may provide a hinge module capable of varying a section where the free stop function may be implemented (which may be referred to hereinafter as a 'flex section') and/or an electronic device in the same.

The foregoing issue may come from the fact that the foldable electronic device is designed so that the section where the free stop function of the foldable electronic device may be implemented is fixed to a specific angle range. The disclosure may provide a hinge module capable of varying a section where the free stop function may be implemented (which may be referred to hereinafter as a 'flex section') and/or an electronic device in the same.

However, the objects of the disclosure are not limited to the foregoing objects but rather may be expanded in various manners without departing from the spirit and scope of the disclosure.

### [Detailed Description of the Invention]

### [Technical Solution]

According to an embodiment of the disclosure, there may be provided a foldable electronic device. The foldable electronic device may include a first housing, a second housing, a hinge module rotatably coupled to the first housing and the second housing, such that the first housing and the second housing are capable of rotating about a folding axis, and a flexible display. The hinge module may include a first rotating member connected to the first housing, a second rotating member connected to the second housing, a first arm member including a first cam structure formed at one end and a first protrusion formed at another end, a second arm member including a second cam structure formed at one end and a second protrusion formed at another end, a third arm member including a third cam structure formed at one end and a third protrusion formed at another end, a fourth arm member including a fourth cam structure formed at one end and a fourth protrusion formed at another end, a first guide member connected to the first rotating member and including a first rail formed on a first surface to receive the first protrusion of the first arm member and a second rail formed on a second surface to receive the second protrusion of the second arm member, and a second guide member connected to the second rotating member and including a third rail formed on a third surface to receive the third protrusion of the third arm member and a fourth rail formed on a fourth surface to receive the fourth protrusion of the fourth arm member.

According to an embodiment of the disclosure, there may be provided a foldable electronic device. The foldable electronic device may include a first housing, a second housing, a hinge module coupled the first housing and the second housing, such that the first housing and the second housing are capable of rotating, and a flexible display. The foldable electronic device may be changed in angle between a folded state and an unfolded state according to an angle between the first housing and the second housing. The hinge module may be formed so that a relative position of the first cam structure with respect to the second cam structure increases when the foldable electronic device changes from the unfolded state to the folded state, and a relative position of the first cam structure with respect to the second cam structure, to be engaged with the first cam structure, decreases when the foldable electronic device changes form the folded state to the unfolded state.

According to an embodiment, there may be provided an electronic device including a hinge module. The electronic device may include a rotating member connected to the housing, a first arm member including a first cam structure at one end and a first protrusion at another end; a second arm member including a second cam structure at one end and a second protrusion at another end; and a guide member connected to the rotating member and including a first rail formed on a first surface to receive the first protrusion of the first arm member and a second rail formed on a second surface to receive the second protrusion of the second arm member.

### [Brief Description of the Drawings]

FIG. 1 is a view illustrating an unfolded state of an electronic device according to various embodiments of the disclosure;
FIG. 2 is a view illustrating a folded state of an electronic device according to various embodiments of the disclosure;
FIG. 3 is a perspective view illustrating an electronic device according to various embodiments of the disclosure;
FIG. 4 is a front view illustrating an electronic device except for a display according to various embodiments of the disclosure;
FIG. 5A is a view illustrating a state when a cam moves according to an embodiment of the disclosure;
FIG. 5B is a view illustrating a state in which a cam is stopped according to an embodiment of the disclosure;
FIG. 6 is a view illustrating a cam profile according to an embodiment of the disclosure;
FIG. 7A is a view illustrating a state in which an angle between a first housing and a second housing of an electronic device is changed according to an embodiment (comparative embodiment);
FIG. 7B is a view illustrating a state in which an angle between a first housing and a second housing is changed when opening an electronic device with one hand according to an embodiment (comparative embodiment);
FIG. 8 is a perspective view illustrating a hinge module 180 according to an embodiment of the disclosure;
FIG. 9 is a perspective view illustrating a folded state of a hinge module according to an embodiment of the disclosure;
FIG. 10 is a plan view illustrating an unfolded state of a hinge module according to an embodiment of the disclosure;
FIG. 11 is a perspective view illustrating a state in which some components are separated in an unfolded state of a hinge module according to an embodiment of the disclosure;
FIG. 12 is a perspective view illustrating an interlocking structure of a hinge module according to an embodiment of the disclosure;
FIG. 13A is a perspective view illustrating a guide member according to an embodiment of the disclosure;
FIG. 13B is a front view illustrating a guide member according to an embodiment of the disclosure;
FIG. 13C is a perspective view illustrating a guide member according to an embodiment of the disclosure;
FIG. 13D is a rear view illustrating a guide member according to an embodiment of the disclosure;
FIG. 14A is a perspective view illustrating a first arm member according to an embodiment of the disclosure;
FIG. 14B is a perspective view illustrating a state in which a first arm member is coupled to a guide member according to an embodiment of the disclosure;
FIG. 14C is a perspective view illustrating a state in which a first protrusion of a first arm member is disposed on a first rail of a guide member according to an embodiment of the disclosure;
FIG. 15A is a perspective view illustrating a second arm member according to an embodiment of the disclosure;
FIG. 15B is a perspective view illustrating a state in which a second arm member is coupled to a guide member according to an embodiment of the disclosure;
FIG. 15C is a perspective view illustrating a state in which a second protrusion of a second arm member is disposed on a second rail of a guide member according to an embodiment of the disclosure;
FIG. 16 is a perspective view illustrating a state in which a second arm member is connected to a first shaft according to an embodiment of the disclosure;
FIG. 17 is a perspective view illustrating a state in which a first elastic member is connected to a first arm member according to an embodiment of the disclosure;
FIG. 18 is a perspective view illustrating a state in which a first elastic member is connected to a second arm member according to an embodiment of the disclosure;
FIG. 19A is a view illustrating behavior of a first protrusion disposed on a first rail and a second protrusion disposed on a second rail and behavior of a first cam structure, a second cam structure, and a third cam structure at each of various angles between a first housing and a second housing according to an embodiment of the disclosure;
FIG. 19B is a view illustrating behavior of an interlocking structure and a fixed structure when an angle between a first housing and a second housing is about 180 degrees according to an embodiment of the disclosure;
FIG. 19C is a view illustrating behavior of an interlocking structure and a fixed structure when an angle between a first housing and a second housing is about 120 degrees according to an embodiment of the disclosure;
FIG. 19D is a view illustrating behavior of an interlocking structure and a fixed structure when an angle between a first housing and a second housing is about 60 degrees according to an embodiment of the disclosure;
FIG. 19E is a view illustrating behavior of an interlocking structure and a fixed structure when an angle between a first housing and a second housing is about 0 degrees according to an embodiment of the disclosure;
FIG. 20A is a view illustrating behavior of an interlocking structure and a fixed structure when an angle between a first housing and a second housing is about 0 degrees according to an embodiment of the disclosure;
FIG. 20B is a view illustrating behavior of a first cam structure, a second cam structure, and a third cam structure when an angle between a first housing and a second housing is about 0 degrees according to an embodiment of the disclosure;
FIG. 20C is a view illustrating behavior of a first protrusion 312b of a first arm member 310-1 when an angle between a first housing and a second housing is about 0 degrees according to an embodiment of the disclosure;
FIG. 21A is a view illustrating behavior of a first protrusion disposed on a first rail and a second protrusion disposed on a second rail and behavior of a first cam structure, a second cam structure, and a third cam structure at each of various angles between a first housing and a second housing according to an embodiment of the disclosure;
FIG. 21B is a view illustrating behavior of an interlocking structure and a fixed structure when an angle between a first housing and a second housing is about 0 degrees according to an embodiment of the disclosure;
FIG. 21C is a view illustrating behavior of an interlocking structure and a fixed structure when an angle between a first housing and a second housing is about 60 degrees according to an embodiment of the disclosure;
FIG. 21D is a view illustrating behavior of an interlocking structure and a fixed structure when an angle between a first housing and a second housing is about 120 degrees according to an embodiment of the disclosure;
FIG. 21E is a view illustrating behavior of an interlocking structure and a fixed structure when an angle between a first housing and a second housing is about 180 degrees according to an embodiment of the disclosure;
FIG. 22A is a view illustrating behavior of an interlocking structure and a fixed structure when an angle between a first housing and a second housing is about 180 degrees according to an embodiment of the disclosure;
FIG. 22B is a view illustrating behavior of a first protrusion 312b of a first arm member 310-1 and behavior of a first cam structure, a second cam structure, and a third cam structure when an angle between a first housing and a second housing is about 180 degrees according to an embodiment of the disclosure;
FIG. 22C is a view illustrating behavior of a first protrusion 312b of a first arm member 310-1 when an angle between a first housing and a second housing is about 180 degrees according to an embodiment of the disclosure;
FIG. 23 is a view illustrating a cam profile in a CTO motion according to an embodiment of the disclosure;
FIG. 24 is a view illustrating a cam profile in an OTC motion according to an embodiment of the disclosure; and
FIG. 25 is a graph illustrating cam torque for each of various sections according to an embodiment of the disclosure.

### [Mode for Carrying out the Invention]

The electronic device according to various embodiments may be one of various types of devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

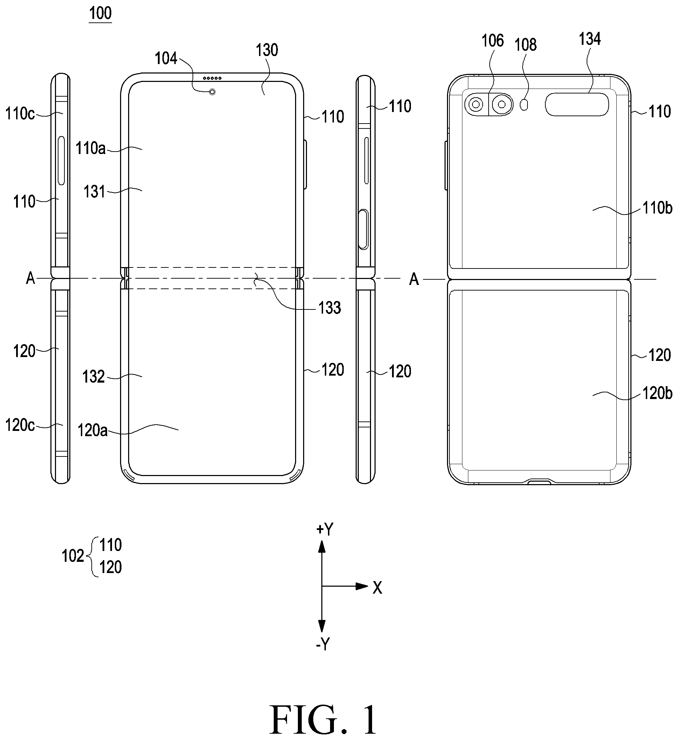

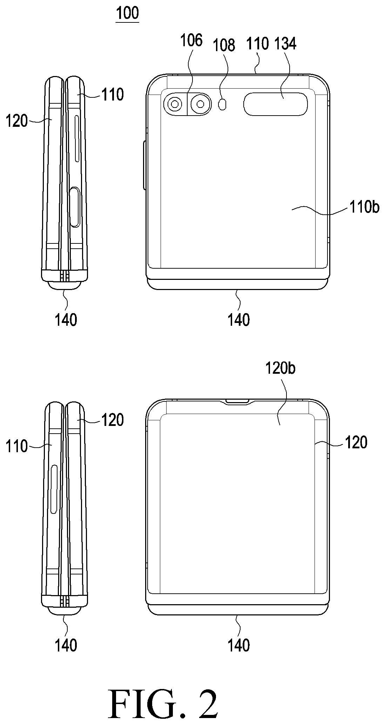

FIG. 1 is a view illustrating an unfolded state of an electronic device according to various embodiments of the disclosure. FIG. 2 is a view illustrating a folded state of an electronic device according to various embodiments of the disclosure.

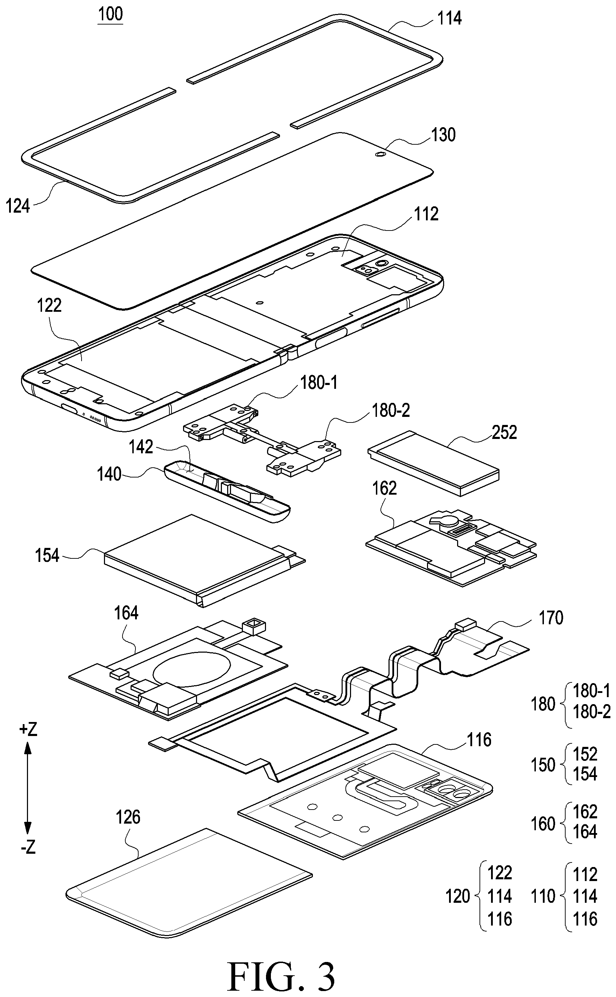

Referring to FIGS. 1 and 2, an electronic device 100 may include a foldable housing 102 (hereinafter, referred to as a housing 102) for receiving components (e.g., the hinge module 180 of FIG. 3) of the electronic device 100 and a flexible or foldable display 130 (hereinafter, referred to as a "display" 130) disposed in a space formed by the housing 102.

According to various embodiments, the housing 102 may include a first housing 110 and a second housing 120.

According to various embodiments, the first housing 110 and/or the second housing 120 may form a portion of the exterior of the electronic device 100. According to an embodiment, the surface where the display 130 is visually exposed is defined as a front surface (e.g., a first front surface 110a and a second front surface 120a) of the electronic device 100 and/or housing 102. A surface opposite to the front surface is defined as a rear surface (e.g., a first rear surface 110b and a second rear surface 120b) of the electronic device 100. Further, a surface surrounding at least a portion of the space between the front surface and the rear surface is defined as a side surface (e.g., the first side surface 110c and the second side surface 120c) of the electronic device 100.

According to various embodiments, the first housing 110 may be rotated about the second housing 120 by a hinge module (e.g., the hinge module 180 of FIG. 3). Thus, the electronic device 100 may turn into a folded state (e.g., FIG. 2) or unfolded state (e.g., FIG. 1). In the folded state of the electronic device 100, the first front surface 110a may face the second front surface 120a and, in the unfolded state, the direction in which the first front surface 110a faces may be the same as the direction in which the second front surface 120a faces. For example, in the unfolded state, the first front surface 110a may be positioned on substantially the same plane as the second front surface 120a. According to an embodiment, the first housing 110 may provide a motion relative to the second housing 120, and the second housing 120 may provide a motion relative to the first housing 110.

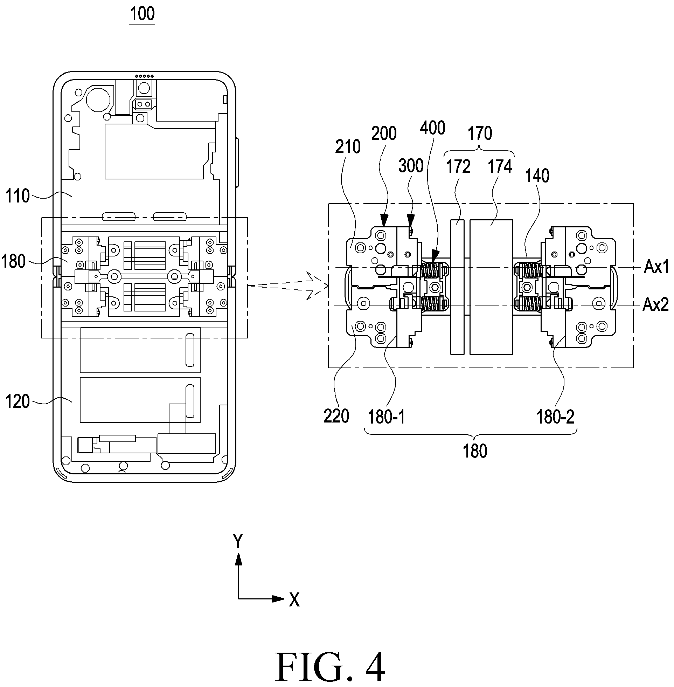

According to various embodiments, the first housing 110 and the second housing 120 are disposed on both sides of the folding axis A and be overall symmetrical in shape with respect to the folding axis A. As described below, the angle between the first housing 110 and the second housing 120 may be changed depending on whether the electronic device 100 is in the unfolded state, the folded state, or an intermediate state between the unfolded state and the folded state. According to an embodiment, the folding axis A may be a virtual axis positioned between (e.g., in the middle) between a first rotational axis (e.g., the first rotational axis Ax1 of FIG. 4) and a second rotational axis (e.g., the second rotational axis Ax2 of FIG. 4). In an embodiment, the first housing 110 and the second housing 120 may rotate on the hinge module 180 about different folding axes. For example, the first housing 110 and the second housing 120 each may be rotatably coupled to the hinge module 180, and may be rotated on the folding axis A or different folding axes to rotate from the position where they are folded together to the position where they are inclined or unfolded side-by-side with respect to each other.

As used herein, "positioned side by side with respect to each other" or "extending side by side with respect to each other" may mean a state in which the two structures (e.g., the housing structures 110 and 120) are at least partially positioned next to each other, or at least their respective portions that are next to each other are disposed parallel to each other. In an embodiment, "disposed side by side with respect to each other" may mean that the two structures are positioned next to each other while facing in the same direction or directions parallel to each other. In the following detailed description, the expressions "side by side" and "parallel" may be used, but will be readily understood based on the shapes and arrangement of the structures with reference to the attached drawings.

According to various embodiments, the electronic device 100 may include a hinge housing 140. The hinge housing 140 may be disposed between the first housing 110 and the second housing 120. According to an embodiment, the hinge housing 140 may be hidden by a portion of the first housing 110 and second housing 120 or be exposed to the outside depending on the state of the electronic device 100. According to an embodiment, the hinge housing 140 may protect the hinge module (e.g., the hinge module 180 of FIG. 3) from an external impact of the electronic device 100. According to an embodiment, the hinge housing 140 may be interpreted as a hinge cover for protecting the hinge module 180.

According to an embodiment, the first housing 110 and the second housing 120 may form different angles or distances depending on whether the electronic device 100 is in an unfolded state (or extended state, flat state, or opened state), a folded state (or closed state), or an intermediate state.

According to an embodiment, as shown in FIG. 1, in the unfolded state of the electronic device 100, the hinge housing 140 may be hidden, and thus not exposed, by the first housing 110 and the second housing 120. As another example, as shown in FIG. 2, in the folded state (e.g., a fully folded state) of the electronic device 100, the hinge housing 140 may be exposed to the outside between the first housing 110 and the second housing 120. As another example, in an intermediate state in which the first housing 110 and the second housing 120 are folded with a certain angle, the hinge housing 140 may be partially exposed to the outside between the first housing 110 and the second housing 120. However, in this case, the exposed area may be less than the fully folded state. In an embodiment, the hinge housing 140 may include a curved surface.

According to various embodiments, the display 130 may mean a display at least a portion of which may be transformed into a flat or curved surface. For example, the display 130 may be formed to be transformable in response to the motion of the second housing 120 relative to the first housing 110. According to an embodiment, the display 130 may include a folding area 133, a first display area 131 disposed on one side of the folding area 133 (e.g., above the folding area 133 (in the +Y direction) of FIG. 1), and a second display area 132 disposed on the other side of the folding area 203 (e.g., under the folding area 133 (in the -Y direction) of FIG. 1). According to an embodiment, the folding area 133 may be formed over the hinge module (e.g., the hinge module 180 of FIG. 3). According to an embodiment, the first display area 131 may be disposed on the first housing 110, and the second display area 132 may be disposed on the second housing 120. According to an embodiment, the display 130 may be accommodated in the first housing 110 and the second housing 120.

However, the segmentation of the display 130 as shown in FIG. 1 is merely an example, and the display 130 may be divided into a plurality of (e.g., four or more, or two) areas depending on the structure or function of the display 200. For example, in the embodiment illustrated in FIG. 1, the display 130 may be divided into the areas by the folding area 133 or folding axis (axis A) extending in parallel with the X axis but, in another embodiment, the display 130 may be divided into the areas with respect to another folding area (e.g., a folding area parallel with the X axis) or another folding axis (e.g., a folding axis parallel with the X axis). According to an embodiment, the display 130 may be coupled with or disposed adjacent to a touch detection circuit, a pressure sensor capable of measuring the strength (pressure) of touches, and/or a digitizer for detecting a magnetic field-type stylus pen.

According to various embodiments, the electronic device 100 may include a rear display 134. The rear display 134 may be disposed to face in a different direction from the display 130. For example, the display 130 may be visually exposed through the front surface (e.g., the first front surface 110a and/or the second front surface 120a) of the electronic device 100, and the rear display 134 may be visually exposed through the rear surface (e.g., the first rear surface 110b) of the electronic device 100.

According to various embodiments, the electronic device 100 may include at least one camera 104 and 106 and a flash 108. According to an embodiment, the electronic device 100 may include a front camera 104 exposed through the front surface (e.g., the first front surface 110a) and/or a rear camera 106 exposed through the rear surface (e.g., the first rear surface 110b). The cameras 104 and 106 may include one or more lenses, an image sensor, a flash, and/or an image signal processor. The flash 108 may include, e.g., a light emitting diode or a xenon lamp. According to an embodiment, two or more lenses (an infrared (IR) camera, a wide-angle lens, and a telephoto lens) and image sensors may be disposed on one surface of the electronic device 100.

Described below are the operation of the first housing 110 and the second housing 120 and each area of the display 130 depending on the operation state (e.g., the unfolded state (extended state) and folded state) of the electronic device 100.

In an embodiment, when the electronic device 100 is in the unfolded state (extended state) (e.g., the state in FIG. 1), the first housing 110 and the second housing 120 form an angle of 180 degrees, and the first surface 110a and the second surface 120a of the display may be disposed to face in the same direction, e.g., to display the screen in directions parallel to each other. Further, the folding area 133 may be coplanar with the first surface 110a and the second surface 120a. In describing various embodiments of the disclosure, when the state of the electronic device 100 is the "unfolded state", it may mean a "fully unfolded state" in which the angle between the first housing 110 and the second housing 120 of the electronic device is 180 degrees.

According to an embodiment, when the electronic device 100 is in the folded state (e.g., the state in FIG. 2), the first housing 110 and the second housing 120 may be disposed to face each other. For example, when the electronic device 100 is in the folded state (e.g., the state in FIG. 2), the first surface 110a and the second surface 131b of the display 130 may face each other while forming a narrow angle (e.g., an angle between 0 and 10 degrees) therebetween. When the electronic device 100 is in the folded state (e.g., the state of FIG. 2), at least a portion of the folding area 133 may form a curved surface having a predetermined curvature. When the state of the electronic device 100 is the "closed state", it may mean a state in which the angle between the first housing 110 and the second housing 120 of the electronic device is 0 degrees or an angle within 10 degrees.

In an embodiment, in the intermediate state of the electronic device 100, the first housing 110 and the second housing 120 may be arranged at a certain angle, e.g., 90 degrees or 120 degrees, therebetween. For example, in the intermediate state, the first surface 110a and the second surface 120a of the display 130 may form an angle which is larger than the angle in the folded state and smaller than the angle in the unfolded state. The folding area 133 may at least partially have a curved surface with a predetermined curvature and, in this case, the curvature may be smaller than that when it is in the folded state. When the state of the electronic device 100 is the "intermediate state", it may mean a state of forming an angle between the angle between the first housing 110 and the second housing 120 in the "unfolded state" and the angle between the first housing 110 and the second housing 120 in the "closed state".

FIG. 3 is a perspective view illustrating an electronic device according to various embodiments of the disclosure. FIG. 4 is a front view illustrating an electronic device except for a display according to various embodiments of the disclosure.

Referring to FIGS. 3 and 4, an electronic device 100 may include a first housing 110, a second housing 120, a display 130, a hinge housing 140, a battery 150, a printed circuit board 160, a flexible printed circuit board 170, and a hinge module 180. The configuration of the first housing 110, the second housing 120, the display 130, and the hinge housing 140 of FIGS. 3 and 4 may be identical in whole or part to the configuration of the first housing 110, the second housing 120, the display 130, and the hinge housing 140 of FIG. 1 and 2.

According to various embodiments, the housing 110 and 120 may include a first supporting member 112 or a second supporting member 122. For example, the first housing 110 may include a first supporting member 112, and the second housing 120 may include a second supporting member 122. According to an embodiment, the first supporting member 112 and/or the second supporting member 122 may support components (e.g., the display 130, the battery 150, and the printed circuit board 160) of the electronic device 100.

According to an embodiment, the first supporting member 112 and/or the second supporting member 122 may be formed of a metal material and/or a non-metal (e.g., polymer) material. According to an embodiment, the first supporting member 112 may be disposed between the display 130 and the battery 150. For example, the display 130 may be coupled to one surface of the first supporting member 112, and the battery 150 and the printed circuit board 160 may be disposed on the other surface.

According to various embodiments, the housing 110 and 120 may include a first deco member 114 and a second deco member 124. For example, the first housing 110 may include the first deco member 114, and the second housing 120 may include the second deco member 124. According to an embodiment, the deco members 114 and 124 may protect the display 130 from external impact. For example, the first deco member 114 may surround at least a portion of a portion (e.g., the first display area 131 of FIG. 1) of the display 130, and the second deco member 124 may surround at least a portion of another portion (e.g., the second display area 132 of FIG. 1) of the display 130.

According to various embodiments, the housings 110 and 120 may include a first rear plate 116 and a second rear plate 126. For example, the first housing 110 may include a first rear plate 116 connected to the first supporting member 112, and the second housing 120 may include a second rear plate 126 connected to the second supporting member 122. According to an embodiment, the rear plates 116 and 126 may form at least a portion of the exterior of the electronic device 100. For example, the first rear plate 116 may form a first rear surface (e.g., the first rear surface 110b of FIG. 1), and the second rear plate 126 may form a second rear surface (e.g., the second rear surface 120b of FIG. 1). According to an embodiment, the first battery 152 and the first printed circuit board 162 may be disposed between the first supporting member 112 and the first rear plate 116. The second battery 154 and the second printed circuit board 164 may be disposed between the second supporting member 122 and the second rear plate 126.

According to various embodiments, the hinge housing 140 may receive at least a portion of the hinge module 180. For example, the hinge housing 140 may include a receiving recess 142 for receiving the hinge module 180. According to an embodiment, the hinge housing 140 may be coupled to the hinge module 180. According to an embodiment, in the unfolded state of the electronic device 100, at least a portion of the hinge housing 140 may be positioned between the hinge module 180 and the housing 110 and 120.

According to various embodiments, the battery 150 may be a device for supplying power to at least one component of the electronic device 100. The battery 189 may include a primary cell which is not rechargeable, a secondary cell which is rechargeable, or a fuel cell. The battery 150 may be integrally or detachably disposed inside the electronic device 100. According to an embodiment, the battery 150 may include a first battery 152 disposed in the first housing 110 and a second battery 154 disposed in the second housing 120. For example, the first battery 152 may be disposed on the first supporting member 112. The second battery 154 may be disposed on the second supporting member 122.

According to various embodiments, a processor, memory, and/or an interface may be mounted on the printed circuit board 160. The processor may include one or more of, e.g., a central processing unit, an application processor, a graphic processing device, an image signal processing, a sensor hub processor, or a communication processor. The memory may include a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 100 with an external electronic device and may include a USB connector, an SD card/multimedia card (MMC) connector, or an audio connector. According to an embodiment, the printed circuit board 160 may include a first printed circuit board 162 disposed in the first housing 110 and a second printed circuit board 164 disposed in the second housing 120.

According to various embodiments, the flexible printed circuit board 170 may electrically connect a component (e.g., first printed circuit board 162) positioned in the first housing 110 with a component (e.g., second printed circuit board 164) positioned in the second housing 120. According to an embodiment, the flexible printed circuit board 170 may cross the hinge housing 140. For example, a portion of the flexible printed circuit board 170 may be disposed in the first housing 110, and another portion thereof may be disposed in the second housing 120. According to an embodiment, the flexible printed circuit board 170 may include a first flexible printed circuit board 172 connected to an antenna and a second flexible printed circuit board 174 connected to the display 130.

According to various embodiments, the hinge module 180 may be connected to the first housing 110 and the second housing 120. For example, the hinge module 180 may include a first rotating member 210 connected to or coupled to the first support member 112 of the first housing 110 and a second rotating member 220 connected to or coupled to the second support member 122 of the second housing 120. According to an embodiment, the first housing 110 may rotate about the second housing 120 by the hinge module 180. For example, the first housing 110 and/or the first rotating member 210 may rotate about the first rotational axis Ax1, and he second housing 120 and/or the second rotating member 220 may rotate about the second rotational axis Ax2. According to an embodiment, the hinge module 180 may rotatably connect the first housing 110 and the second housing 120 from a folded state (e.g., FIG. 2) to an unfolded state (e.g., FIG. 1). According to an embodiment, the hinge module 180 may be disposed between the housing 102 and the display 130. According to an embodiment, the second rotational axis Ax2 may be disposed substantially parallel to the first rotational axis Ax1.

According to various embodiments, the hinge module 180 may include a rotating structure 200, an interlocking structure 300 and/or a fixing structure 400.

According to various embodiments, the rotating structure 200 may substantially implement or guide rotation of the first housing 110 and/or the second housing 120. According to an embodiment, the rotating structure 200 may provide a first rotational axis Ax1 and a second rotational axis Ax2. According to an embodiment, the rotating structure 200 may be connected to the first supporting member 112 of the first housing 110 and the second supporting member 122 of the second housing 120.

According to various embodiments, the interlocking structure 300 may interwork the rotation of the first housing 110 with the rotation of the second housing 120. According to an embodiment, the interlocking structure 300 may transfer at least a portion of the force applied to the first housing 110 to the second housing 120 or transfer at least a portion of the force applied to the second housing 120 to the first housing 110. For example, the interlocking structure 300 may rotate the second housing 120 by substantially the same angle as the angle at which the first housing 110 is rotated, using a gear.

According to various embodiments, the fixing structure 400 may position the first housing 110 and the second housing 120 at a certain angle. For example, the fixing structure 400 may provide pressure to the interlocking structure 300 to prevent or reduce movement and/or rotation of the first housing 110 and/or the second housing 120 of the electronic device 100. For example, when the user applies a predetermined degree of or more external force, the hinge module 180 may allow the first housing 110 and/or the second housing 120 to rotate, and if no or less than the predetermined degree of external force is applied, the hinge module 140 may keep the first housing 110 and/or the second housing 120 stationary using the first fixing structure 400.

According to an embodiment, the hinge module 180 may include a plurality of hinge modules 180-1 and 180-2 disposed in parallel. For example, the hinge modules 180 may include a first hinge module 180-1 disposed on the hinge housing 140 and a second hinge module 180-2 facing the first hinge module 180-1. According to an embodiment, the first hinge module 180-1 may be symmetrical with the second hinge module 180-2 with respect to a virtual line drawn in the length direction (e.g., the Y-axis direction) of the electronic device 100. Hereinafter, The description of the electronic device 100 including the hinge module 180 of the disclosure focuses primarily on the first hinge module 180-1, but may also apply to the second hinge module 180-2.

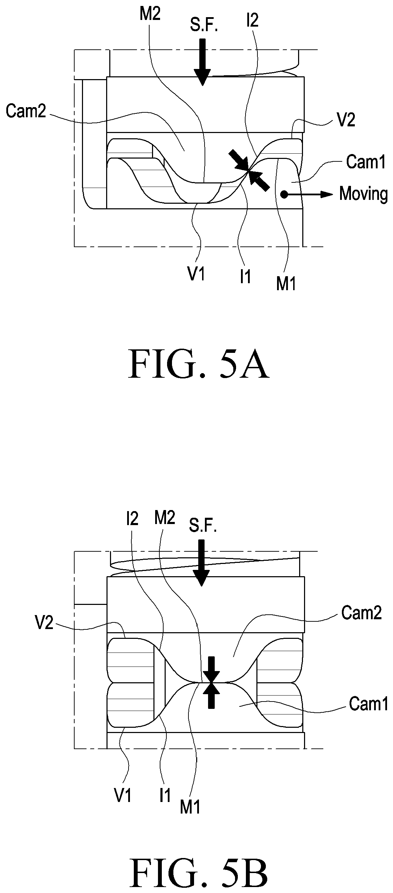

FIG. 5A is a view illustrating a state when a cam moves according to an embodiment of the disclosure. FIG. 5B is a view illustrating a state in which a cam is stopped according to an embodiment of the disclosure.

The electronic device 100 including the hinge module 180 of the disclosure may provide a free stop function. The free stop may be a function that allows the first housing 110 and the second housing 120 to stop at a certain angle when the user folds or unfolds the foldable housing of the electronic device. The free stop function may also be referred to as a flex or flex mode function.

Referring to FIGS. 5A and 5B, the hinge module 180 may include two cams Cam1 and Cam2. Here, one of the two cams may be a cam Cam1 included in the interlocking structure 300, and the other may be a cam Cam2 included in the fixing structure 400. The cam Cam1 included in the interlocking structure 300 is a cam that moves based on an angle between the first housing (e.g., the first housing 110 of FIG. 1) and the second housing (e.g., the second housing 120 of FIG. 1) of the electronic device (e.g., the electronic device 100 of FIG. 1), and the cam Cam2 included in the fixing structure 400 may be a fixed cam that may move on the cam axis by a spring disposed on the cam axis but does not rotate with respect to the cam axis. The cam Cam1 included in the interlocking structure 300 and the cam Cam2 included in the fixing structure 400 may include valley portions V1 and V2 and mountain portions M1 and M2, respectively. In both the cam Cam1 included in the interlocking structure 300 and the cam Cam2 included in the fixing structure 400, the valley portions and the mountain portions may be alternately arranged along the circumference. Further, the cam Cam1 included in the interlocking structure 300 and the cam Cam2 included in the fixing structure 400 may include inclined portions I1 and I2 between the valley portions V1 and V2 and the mountain portions M1 and M2, respectively. In a state in which the valley portion V1 or the mountain portion M1 of the cam Cam1 included in the interlocking structure 300 contacts the mountain portion M2 or the valley portion V2 of the cam Cam2 included in the fixing structure 400, the relative positions of the cam Cam1 included in the interlocking structure 300 and the cam Cam2 included in the fixing structure 400 may not change even if a spring force is transferred in the direction of the cam axis unless a separate external force is applied by the frictional force acting on the cam. However, as shown in FIG. 5A, in a state in which a certain external force acts so that the inclined portion V1 of the cam Cam1 included in the interlocking structure 300 and the inclined portion V2 of the cam Cam2 included in the fixing structure 400 contact each other, the cam Cam1 included in the interlocking structure 300 may be moved in the centrifugal direction perpendicular to the cam axis by the spring force in the direction of the cam axis. Accordingly, relative positions of the cam Cam1 included in the interlocking structure 300 and the cam Cam2 included in the fixing structure 400 may be varied. On the other hand, as shown in FIG. 5B, if the mountain portion M1 of the cam Cam1 included in the interlocking structure 300 and the mountain portion M2 of the cam Cam2 included in the fixing structure 400 contact each other, the relative positions of the cam Cam1 included in the interlocking structure 300 and the cam Cam2 included in the fixing structure 400 may remain unchanged even if a spring force is transferred in the direction of the cam axis, unless a separate external force is applied. However, in the embodiment of FIG. 5B, the mountain portion M1 of the cam Cam1 included in the interlocking structure 300 and the mountain portion M2 of the cam Cam2 included in the fixing structure 400 face each other but are not engaged with each other, and thus the relative positions of the cam Cam1 included in the interlocking structure 300 and the cam Cam2 included in the fixing structure 400 may be easily changed even with a small external force. In the state of the cam shown in FIG. 5B, the free stop operation may be implemented.

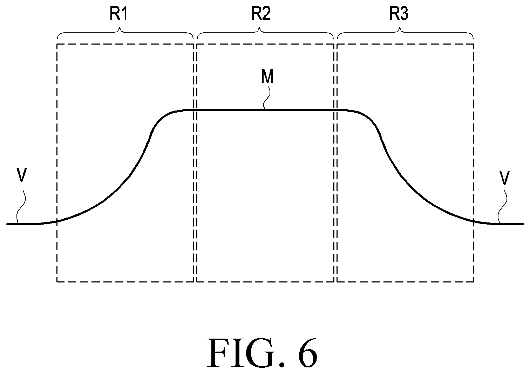

FIG. 6 is a view illustrating a cam profile according to an embodiment of the disclosure.

FIG. 6 may be a diagram illustrating the behavior of the cam when two cams each including a valley portion and a mountain portion move relative to each other. The cam profile may mean the shape (or contour) of the cam of the interlocking structure 300 and/or the fixing structure 400 included in the hinge module 180. According to an embodiment, the cam profile of FIG. 6 may mean a trajectory of any point (e.g., the mountain portion M1) on the cam Cam1 included in the interlocking structure 300 when the cam Cam2 included in the fixing structure 400 does not move but the cam Cam1 included in the interlocking structure 400 moves, as shown in the embodiments shown in FIGS. 5A and 5B. As shown in FIG. 6, the cam profile may have a shape corresponding to the shape of the cam, i.e., it may have a valley portion V and a valley portion M, and the length and curvature of the line forming the valley portion V and the valley portion M of the cam profile may vary according to embodiments. Referring to FIG. 6, the valley portion V of the cam profile may correspond to the sections R1 and R3 in which the cam Cam1 included in the interlocking structure 300 is moved by a spring force (hereinafter, referred to as 'non-flex sections R1 and R3'), and the mountain portion M of the cam profile may correspond to the section R2 in which the cam Cam1 included in the interlocking structure 300 is not moved by a spring force. According to an embodiment, the free stop function may be implemented according to how the cam profile of the hinge module 180 is designed. For example, the free stop function may be implemented by including a section R2 in which the cam profile is not moved by spring force even if the angle between the first housing (e.g., the first housing 110 of FIG. 1) and the second housing (e.g., the second housing 120 of FIG. 1) of the electronic device (e.g., the electronic device 100 in FIG. 1) changes.

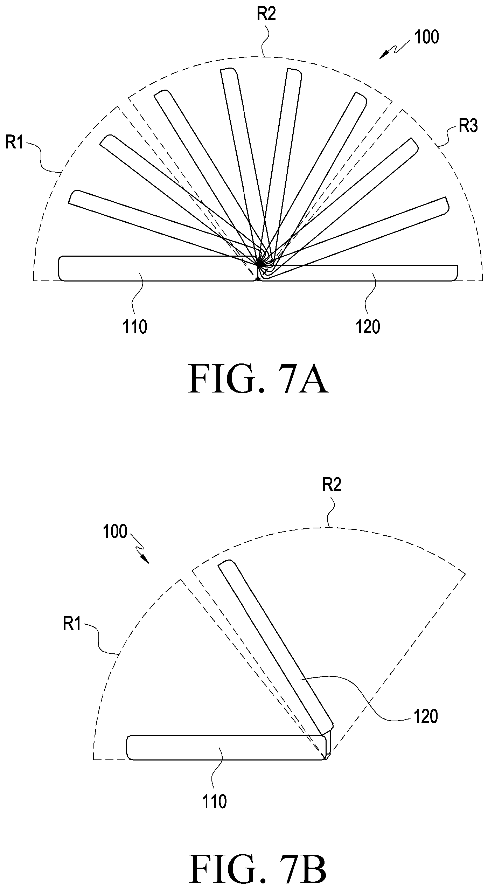

FIG. 7A is a view illustrating a state in which an angle between a first housing 110 and a second housing of an electronic device is changed according to an embodiment (comparative embodiment). FIG. 7B is a view illustrating a state in which an angle between a first housing and a second housing is changed when opening an electronic device with one hand according to an embodiment (comparative embodiment).

Referring to FIG. 7A, an electronic device according to an embodiment (comparative embodiment) may be designed to implement a free stop function when the angle between the first housing 110 and the second housing 120 forms a designated angle (e.g., 60 to 120 degrees). For example, if the angle between the first housing 110 and the second housing 120 is between 60 and 120 degrees, the angle between the first housing 110 and the second housing (e.g., the second housing 120 of FIG. 1) may be maintained unless a separate external force is applied. When the angle between the first housing 110 and the second housing 120 is less than 60 degrees and more than 120 degrees, the angle of the electronic device may be changed by the spring force of the hinge module 180 without applying a separate external force. As such, the electronic device may be operated separately in the flex section R2 in which the free stop function corresponding to various angles between the first housing 110 and the second housing 120 is implemented and in the non-flex sections R1 and R3 in which the free stop function is not implemented.

Meanwhile, referring to FIGS. 7A and 7B together, when the user opens the electronic device that operates separately in the flex section R2 and the non-flex sections R1 and R3, the user may have to apply a greater force to change the angle between the first housing 110 and the second housing 120 in which the angle is maintained in the flex section R2 as the flex section R2 is longer. When the user opens the electronic device that operates separately in the flex section R2 and the non-flex sections R1 and R3 with one hand or with less effort, the angle between the first housing 110 and the second housing 120 may be the flex section R2 as shown in FIG. 7B. When the flex section R2 of the electronic device increases, the probability that the angle between the first housing 110 and the second housing 120 is present in the flex section R2 may increase. For example, the user who wants to open the electronic device with one hand is required to use both hands or apply a greater force to open the electronic device, which may deteriorate the convenience of use. If the flex section R2 is reduced to reduce or prevent the deterioration of convenience of use, the free stop function of the foldable electronic device may not be effectively exhibited.

Hereinafter, a hinge module 180 having a variable flex section and an electronic device including the same are provided.

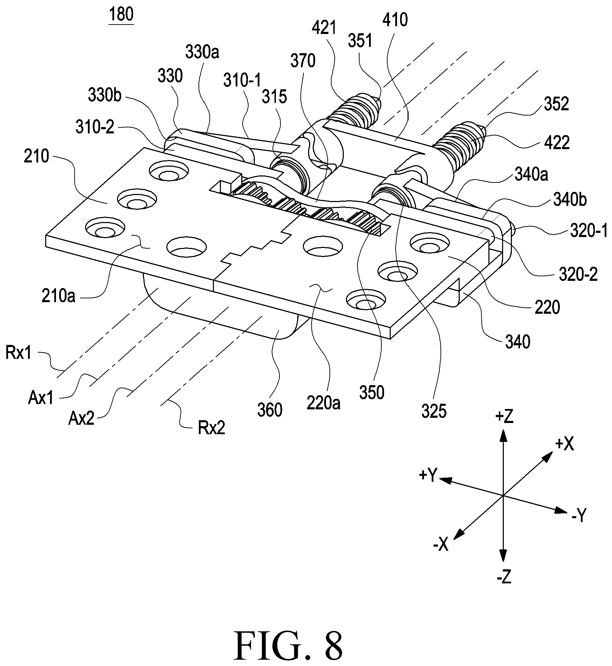

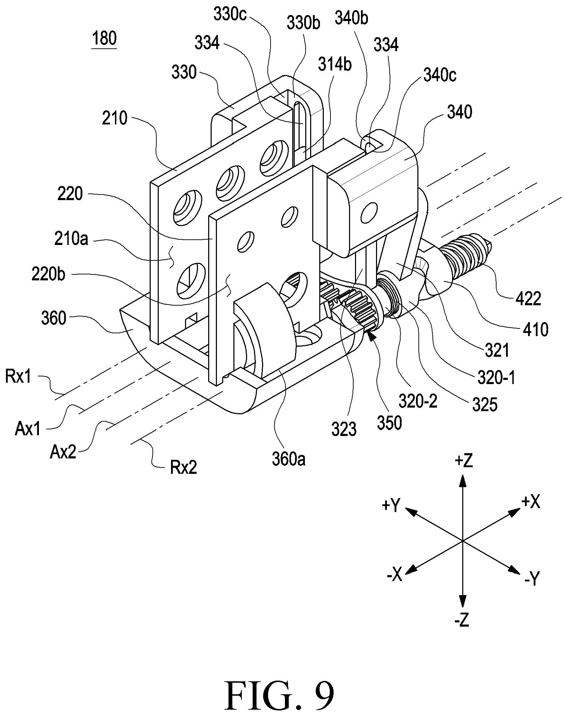

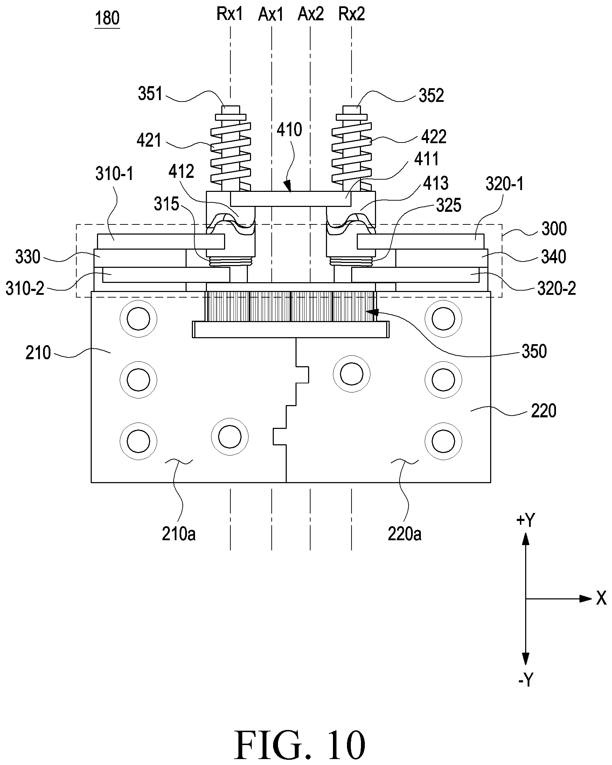

FIG. 8 is a perspective view illustrating an unfolded state of a hinge module according to an embodiment of the disclosure. FIG. 9 is a perspective view illustrating a folded state of a hinge module according to an embodiment of the disclosure. FIG. 10 is a plan view illustrating an unfolded state of a hinge module according to an embodiment of the disclosure.

In the following detailed description, the vertical width direction (length direction) of the electronic device 100 may be defined as the 'Y-axis direction', the horizontal width direction as the 'X-axis direction', and/or the height direction as the 'Z-axis direction'. In describing the direction, when 'negative/positive (-/+)' is not shown, it may be interpreted as including both the + direction and the - direction unless separately defined. In other words, the 'X-axis direction' may be interpreted as including both the +X direction and the -X direction, the 'Y-axis direction' may be interpreted as including both the +Y direction and the -Y direction, and the 'Z-axis direction' may be interpreted as including both the +Z direction and the -Z direction. In describing the direction, facing in any one of the three axes of the orthogonal coordinate system may include facing in a direction parallel to the axis. It should be noted that the arrangement of the components is defined with respect to the Cartesian coordinate system shown in the drawings in the description of the drawings, and the description of these directions or components do not limit various embodiments of the disclosure. In addition to the above-described embodiment, in various examples, including FIG. 8 to be described below, the direction in which the axis of the hinge module 180 (first rotational axis Ax1 and second rotational axis Ax2) is directed is shown as parallel to the X-axis, but it is only intended to help understand the structure of the hinge module of the disclosure but does not limit any direction. In the following description, the first surface 330a of the guide member (e.g., the first guide member 330) faces in the first direction (+X direction), the second surface 330b faces in the second direction (-X direction), and the third surface 330c faces in the third direction (+Z direction), which is merely for convenience of description and does not limit any direction.

Referring to FIGS. 8 to 10, the hinge module 180 according to an embodiment of the disclosure may include a first rotating member 210, a second rotating member 220, a first arm member 310-1, a second arm member 310-2, a first guide member 330, a third arm member 320-1, a fourth arm member 320-2, and a second guide member 340. Here, the first arm member 310-1 and the second arm member 310-2 may be connected to the first rotating member 210, and the third arm member 320-1 and the fourth arm member 320-2 may be connected to the second rotating member 220.

According to various embodiments, the first rotating member 210 and the second rotating member 220 may have substantially the same structure, and thus the components provided in the rotating members 210 and 220 may also be formed to have the same structure. Accordingly, the description of the components provided in the rotating members 210 and 220 may be described without being limited to whether the components are included in the first rotating member 210 or the second rotating member 220. Further, the first arm member 310-1, the third arm member 320-1, the second arm member 310-2, the fourth arm member 320-2, the first guide member 330 and the second guide member 340 may also have substantially the same structure. Sub components of substantially the same two components may be described without distinguishing between 'first' and 'second'. Hereinafter, in describing sub components of substantially the same two components, e.g., a description of sub components included in a 'first component' may be equally applied to a description of sub components included in a 'second component'. Accordingly, the description of the sub components included in the 'second component' may be omitted within a range overlapping the description of the sub components included in the 'first component', and the description of the sub components included in the 'first component' may be applied to the description of the sub components included in the 'second component'.

In the hinge module 180 according to various embodiments of the disclosure, a plurality of components for driving the hinge module 180 each may be provided in pair to be symmetrically disposed left/right with respect to the folding axis (e.g., the folding axis A of FIG. 1). For example, the hinge module 180 may include a first rotating member 210 and a second rotating member 220 as components for driving, and the first rotating member 210 and the second rotating member 220 may be provided left/right symmetrically with respect to the folding axis (e.g., the folding axis A of FIG. 1) as substantially the same components. The description of the first rotating member 210 may be applied to the second rotating member 220 that is symmetrical with respect to the folding axis (e.g., the folding axis A of FIG. 1). The description of components symmetrically arranged left and right with respect to the folding axis (e.g., the folding axis A of FIG. 1) may also be applied to the description of other components included in the hinge module 180 (e.g., first arm member 310-1 and third arm member 320-1, second arm member 310-2, or first guide member 330 and second guide member 340).

Referring to FIGS. 8 to 10, according to various embodiments, one sides of the first rotating member 210 and the second rotating member 220 may be coupled to the fixing bracket 360, and the other sides thereof may be coupled to the first guide member 330 and the second guide member 340. The first rotating member 210 and the second rotating member 220 may include substantially flat portions (e.g., the front surfaces 210a and 220a or the rear surfaces 210b and 220b). Although not shown in the drawings, according to an embodiment, at least some areas in the first rotating member 210 and the second rotating member 220 may be formed to have a curved shape to have a predetermined curvature. The first rotating member 210 and the second rotating member 220 may be coupled to the fixing bracket 360 to be rotatable about the first rotational axis Ax1 and the second rotational axis Ax2. In this case, the fixing bracket 360 may include a first guide rail 360a for guiding the first rotating member 210 to be rotatable about the first rotational axis Ax1, and a second guide rail (not shown) for guiding the second rotating member 220 to be rotatable about the second rotational axis Ax2. The first rotating member 210 and the second rotating member 220 may be fixedly coupled to the first guide member 330 and the second guide member 340. The first guide member 330 and the second guide member 340 may be coupled to first surfaces (e.g., the rear surfaces 210b and 220b) of the first rotating member 210 and the second rotating member 220, and when the first rotating member 210 and the second rotating member 220 rotate with respect to the fixing bracket 360 about the first rotational axis Ax1 and the second rotational axis Ax2, the first guide member 330 and the second guide member 340 fixedly connected to the first rotating member 210 and the second rotating member 220 may also rotate with respect to the first rotational axis Ax1 and the second rotational axis Ax2.

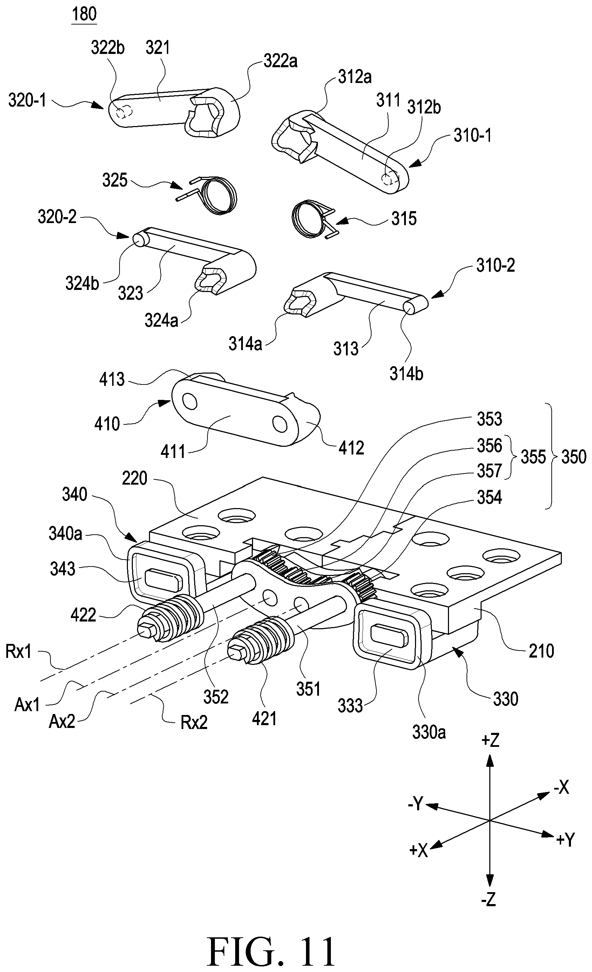

According to an embodiment, the hinge module 180 may include a gear member 350 including a first gear (the first gear 353 of FIG. 11 to be described below), a second gear (the second gear 354 of FIG. 11 to be described below), and/or an interlocking gear (the interlocking gear 355 of FIG. 11 to be described below). As is described below in detail, the interlocking gear 355 may include gears positioned on the first rotational axis Ax1 and the second rotational axis Ax2, which are axes where the first rotating member 210 and the second rotating member 220 rotate. Further, the first gear 353 may include a first shaft 351 that may rotate with respect to the first interlocking axis Rx1 parallel to the first rotational axis Ax1 and a tooth portion provided to be engaged with the tooth portion of the interlocking gear 355 on one side of the first shaft 351. Further, e.g., the second gear 354 may include a second shaft 352 that may rotate with respect to the second interlocking axis Rx2 parallel to the second rotational axis Ax2 and a tooth portion provided to be engaged with the tooth portion of the interlocking gear 355 on one side of the second shaft 352. An opening may be formed in one side of the first rotating member 210 and the second rotating member 220 so as not to interfere with the gear member 350. A space in which the gear member 350 is seated may be provided on one side of the fixing bracket 360, and the first gear 353 and the second gear 354 of the gear member 350 may rotate around the first interlocking axis Rx1 and the second interlocking axis Rx2 while being seated on the fixing bracket 360.

One side of the first arm member 310-1 may be connected to the first shaft 351 on the first rotational axis Ax1, and the other side thereof may be connected to the first surface 330a of the first guide member 330. One side of the first arm member 310-1 may be rotatably connected to the first shaft 351 on the first rotational axis Ax1, and the other side may be connected to linearly move on the rail (e.g., the first rail 333 of FIG. 11 to be described below) formed on the first surface 330a of the first guide member 330. One side of the second arm member 310-2 may be connected to the first shaft 351 on the first rotational axis Ax1, and the other side thereof may be connected to the second surface 330b of the first guide member 330. One side of the second arm member 310-2 may be rotatably connected to the first shaft 351 on the first rotational axis Ax1, and the other side may be connected to linearly move on the rail (e.g., the second rail 334 of FIG. 11 to be described below) formed on the second surface 330b of the first guide member 330.

An elastic member 315 may be provided between the first arm member 310-1 and the second arm member 310-2. The elastic member 315 may be, e.g., a torsional spring. One side of the elastic member 315 is connected to the first arm member 310-1, and the other side is connected to the second arm member 310-2, causing a relative movement between the first arm member 310-1 and the second arm member 310-2 when the first arm member 310-1 and the second arm member 310-2 form a predetermined angle. For example, the elastic member 315 may apply a force in a direction in which the first cam structure 312a of the first arm member 310-1 and the second cam structure 314a of the second arm member 310-2 are opened without being engaging with each other.

The description of the first arm member 310-1, the second arm member 310-2, and the elastic member 315 is a description of components connected to the first rotating member 210, which may be applied to the description of the third arm member 320-1, the fourth arm member 320-2, and the elastic member 325 connected to the second rotating member 220.

The hinge module 180 serves as a fixing member (e.g., the fixing member 400 of FIG. 4) and may include a fixing cam member 410 and elastic members 421 and 422. According to an embodiment, the elastic members 421 and 422 may include two elastic members 315 and 325 provided to surround the first shaft 351 and the second shaft 352, respectively. The fixing cam member 410 is a non-rotating component, and may receive a force from the elastic member in the direction of the first interlocking axis Rx1 and the second interlocking axis Rx2 and move in a direction parallel to the first interlocking axis Rx1 and the second interlocking axis Rx2. The fixing cam member 410 may include a fixing cam structure 412, 413 which is engaged with the first cam structure 312a and/or the third cam structure 322a of the first arm member 310-1 and/or the third arm member 320-1 and is also engaged with the second cam structure 314a and/or the fourth cam structure 324a of the second arm member 310-2 and/or the fourth arm member 320-2. For example, the fixing cam member 410 may include a fifth cam structure 412 provided on one side and engaged with the first cam structure 312a and/or the third cam structure 322a, and a sixth cam structure 413 provided on the other side and engaged with the second cam structure 314a and/or the fourth cam structure 324a. The fixing cam member 410 may be supported by the elastic member 421, 422 to press the first arm member 310-1 and/or the third arm member 320-1. In the disclosure, the elastic members 315 and 325 disposed between the first arm member 310-1 and the second arm member 310-2 and the third arm member 320-1 and the fourth arm member 320-2 may be referred to as a 'first elastic member 315 and/or second elastic member 325', and the elastic members 421 and 422 supporting the fixing cam member 410 may be referred to as a 'third elastic member 421 and/or fourth elastic member 422', respectively.

Further, a coupling member (e.g., a bolt or a screw) (not shown) may be coupled to a hole formed through one surface (e.g., the front surfaces 210a and 220a) of the first rotating member 210 and the second rotating member 220. It may be coupled to the first housing 110 and the second housing 120 through the coupling member, or may be coupled to other components (e.g., a supporting member or a bracket) in the electronic device.

Referring to FIG. 10, the hinge module 180 may include an interlocking structure 300. The configuration of the interlocking structure 300 of FIG. 10 may be identical in whole or part to the configuration of the interlocking structure 300 of FIG. 4. Hereinafter, the interlocking structure 300 is described in more detail with reference to FIGS. 11 to 18.

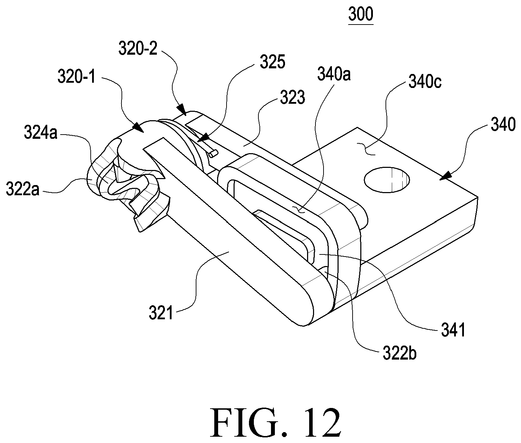

FIG. 11 is a perspective view illustrating a state in which some components are separated in an unfolded state of a hinge module according to an embodiment of the disclosure. FIG. 12 is a perspective view illustrating an interlocking structure of a hinge module according to an embodiment of the disclosure. In describing the interlocking structure 300, in the embodiments of FIGS. 11 and 12, the first arm member 310-1, the second arm member 310-2, the first guide member 330, and the first elastic member 315 connected to the first rotating member 210 may be mainly described, and the following description may be applied to the third arm member 320-1, the fourth arm member 320-2, the second guide member 340, and the second elastic member 325 connected to the second rotating member 220.

Referring to FIG. 11, the hinge module 180 may include a first arm member 310-1 including one side connected to the first shaft 351 on the first rotational axis Ax1 and the other side connected to the first surface 330a of the first guide member 330. The first arm member 310-1 may be connected to the first rotating member 210.

The third arm member 320-1 has substantially the same component as the first arm member 310-1, and may have a symmetrical shape and arrangement shape with the first arm member 310-1 with respect to the hinge axis A. For example, the electronic device may include a pair of arm members (first arm member 310-1 and third arm member 320-1) that are disposed linearly symmetrically with respect to the hinge axis A.

Referring to FIG. 11, the first arm member 310-1 may include a first body portion 311, a first cam structure 312a formed at one end of the first body portion 311, and a first protrusion 312b formed at the other end of the first body portion 311. The third arm member 320-1 may include a third body portion 321, a third cam structure 322a formed at one end of the third body portion 321, and a third protrusion 322b formed at the other end of the third body portion 321. In the hinge module 180, the first cam structure 312a and the third cam structure 322a may protrude in a first direction (+X direction), and the first protrusion 312b and the third protrusion 322b may protrude in a second direction (-X direction) opposite to the first direction. Of course, the hinge module 180 here is the first hinge module 180-1 of FIG. 4, and if it is the hinge module 180-2 of FIG. 4, the first cam structure 312a and the third cam structure 322a may protrude in the second direction (-X direction), and the first protrusion 312b and the third protrusion 322b may protrude in the first direction (+X direction) opposite to the second direction. In the embodiment of FIG. 11, the first protrusion 312b and the third protrusion 322b may be inserted into the first rail 333 and the third rail 343 respectively formed on the first surface 330a and the third surface 340a of the first guide member 330 and the second guide member 340, and the first protrusion 312b and the third protrusion 322b may be configured to move on the first rail 333 and the third rail 343, respectively, in response to the movements of the first rotating member 210 and the second rotating member 220. In this case, the first protrusion 312b and the third protrusion 322b may be configured to slide linearly in at least some sections of the first rail 333 and the third rail 343 and, in at least some sections, turn the direction and then slide linearly.

Referring to FIG. 11, one side of the hinge module 180 may be connected to the first shaft 351 on the first rotational axis Ax1, and the other side may include a second arm member 310-2 connected to the second surface 330b of the first guide member 330. The second arm member 310-2 may be connected to the second rotating member 220 and may also be referred to as a second arm member 310-2.

The fourth arm member 320-2 may have substantially the same component as the second arm member 310-2, and may have a symmetrical shape and arrangement shape with the second arm member 310-2 with respect to the hinge axis A. For example, the electronic device may include a pair of arm members (second arm member 310-2 and fourth arm member 320-2) that are disposed linearly symmetrically with respect to the hinge axis A.

Referring to FIG. 11, the second arm member 310-2 may include a second body portion 313, a second cam structure 314a formed at one end of the second body portion 313, and a second protrusion 314b formed at the other end of the second body portion 313. The fourth arm member 320-2 may include a fourth body portion 323, a fourth cam structure 324a formed at one end of the fourth body portion 323, and a fourth protrusion 324b formed at the other end of the fourth body portion 323. In the hinge module 180, the second cam structure 314a and the fourth cam structure 324a may protrude in the first direction (+X direction), and the second protrusion 314b and the fourth protrusion 324b may also protrude in the first direction (+X direction). In the embodiment of FIG. 11, the second protrusion 314b and the fourth protrusion 324b may be inserted into the second rail (e.g., the second rail 334 of FIG. 9) and the fourth rail (e.g., the fourth rail 344 of FIG. 9) formed on the second surface (e.g., the second surface 330b of FIG. 9) and the fourth surface (e.g., the fourth surface 340b of FIG. 9) of the first guide member 330 and the second guide member 340, respectively, and the second protrusion 314b and the fourth protrusion 324b may be configured to move on the second rail 334 and the fourth rail 344 in response to the movements of the first rotating member 210 and the second rotating member 220. In this case, the second protrusion 314b and the second protrusion 324b may slide linearly in at least some sections of the second rail 334 and the fourth rail 344.

Referring to FIGS. 11 and 12, the first cam structure 312a of the first arm member 310-1 and the second cam structure 314a of the second arm member 310-2 may have a hollow portion formed therein, and the first shaft 351 may be disposed to penetrate the hollow portion. According to an embodiment, the second cam structure 314a of the second arm member 310-2 may be disposed on the inner circumference of the first cam structure 312a of the first arm member 310-1, and the first shaft 351 may be disposed on the inner circumference of the second cam structure 314a of the second arm member 310-2. According to an embodiment, a cross section of the inner circumference of the second cam structure 314a of the second arm member 310-2 and a cross section of the first shaft 351 may be formed in, e.g., an asymmetric cross sectional structure (e.g., a D-cut cross sectional structure). Therefore, an end portion having an asymmetric cross sectional structure of the first shaft 351 may be assembled to be press-fitted into the inner circumference of the second cam structure 314a of the second arm member 310-2. According to an embodiment, according to the arrangement of the second cam structure 314a of the second arm member 310-2 on the inner circumference of the first cam structure 312a of the first arm member 310-1, the first cam structure 312a may be referred to as an "outer cam," and the second cam structure 314a may be referred to as an "inner cam."

Referring back to FIG. 11, the fixing cam member 410 may include a body portion 411 and fixing cam structures 412 and 413 protruding from the body portion 411 in the second direction (-X direction). For example, the fixing cam structure 410 may include a fifth cam structure 412 and a sixth cam structure 413 as fixing cam structures 412 and 413. Each of the two cam structures (the fifth cam structure 412 and the sixth cam structure 413) of the fixing cam member 410 includes a hollow portion through which the first shaft 351 and the second shaft 352 pass, and the first shaft 351 and the second shaft 352 may be disposed in the hollow portions. The fifth cam structure 412 may be engaged with the first cam structure 312a of the first arm member 310-1 and the second cam structure 314a of the second arm member 310-2, and the sixth cam structure 413 may be engaged with the third cam structure 322a of the third arm member 320-1 and the fourth cam structure 324a of the fourth arm member 320-2.

According to various embodiments, the gear member 350 may include an interlocking gear 355 disposed between the first gear 353 and the second gear 354. The interlocking gear 355 may include a plurality of idle gears (e.g., two idle gears). The plurality of idle gears may rotate around a first rotational axis Ax1 and a second rotational axis Ax2, respectively. Further, the plurality of idle gears may include tooth portions engaged with adjacent gears. The tooth portions of the plurality of idle gears may be connected to the tooth portion of the first gear 353 and the tooth portion of the second gear 354. According to an embodiment, the rotation of the first gear 353 may be transferred to the second gear 354 through the interlocking gear 355, and the rotation of the second gear 354 may be transferred to the first gear 353 through the interlocking gear 355.

In the disclosure, it is possible to provide a structure in which the cam structures 312a and 314a included in the first arm member 310-1 and the second arm member 310-2 are disposed to at least partially overlap to change the flex section (e.g., the flex section R2 of FIGS. 7A and 7B) in which the free stop function is implemented. For example, as shown in FIG. 12, the hinge module 180 may have a first cam structure 312a and a second cam structure 314a in which the first arm member 310-1 and the second arm member 310-2 have cam profiles of similar shapes, and dispose the second cam structure 314a inside the first cam structure 312a. In this case, the first cam structure 312a is a so-called outer cam, which may be formed to have a cam profile in which the sizes of the valley portion and the mountain portion are slightly large, as compared to the second cam structure 314a, and the second cam structure 314a is an so-called inner cam, which may be formed to have a cam profile in which the sizes of the valley portion and the mountain portion are relatively large as compared with the first cam structure 312a. By including the configuration, the hinge module 180 of the disclosure may perform an operation of changing the first housing 110 from a folded state to an unfolded state with respect to the second housing 120 (hereinafter, referred to as 'close to open (CTO) motion'), or an operation of changing from an unfolded state to a folded state (hereinafter, referred to as 'open to close (OTC) motion'). In the disclosure, in order to change the flex section, the relative positions of the first cam structure 312a and the second cam structure 314a may be varied in CTO motion and OTC motion. For example, in CTO motion and OTC motion, the overlapping area of the first cam structure 312a and the second cam structure 314a may vary when the cam structure is viewed from a side surface of the hinge module. In the CTO motion, the first cam structure 312a and the second cam structure 314a are disposed to completely overlap each other, so that a section engaged with the fifth cam structure 412 of the fixing cam member 410 may be formed to be short. According to another embodiment, in OTC motion, the first cam structure 312a and the second cam structure 314a may be misaligned to overlap each other relatively less, so that the section engaged with the fifth cam structure 412 of the fixing cam member 410 may be formed to be relatively longer. In the following description, for convenience, the state in which the first cam structure 312a and the second cam structure 314a completely overlap each other in CTO motion may be defined as 'the first cam structure 312a and the second cam structure 314a are cam-overlapped (or cam engaged)', and the state in which the first cam structure 312a and the second cam structure 314a are misaligned to overlap relatively less in OTC motion may be defined as 'the first cam structure 312a and the second cam structure 314a are misaligned (cam spread)'. In summary, the foldable electronic device 100 of the disclosure may be changed in angle between a folded state and an unfolded state according to an angle between the first housing 110 and the second housing 120. The hinge module 180 may be formed so that a relative position of the first cam structure 312a with respect to the second cam structure 314a increases when the foldable electronic device 100 changes from the unfolded state to the folded state (to be engaged with the fixing cam structure 412), and a relative position of the first cam structure 312a with respect to the second cam structure 314a (to be engaged with the first cam structure 412) decreases when the foldable electronic device 100 changes form the folded state to the unfolded state. The above description may be similarly applied to the third cam structure 322a and the fourth cam structure 324a included in the third arm member 320-1 and the fourth arm member 320-2.

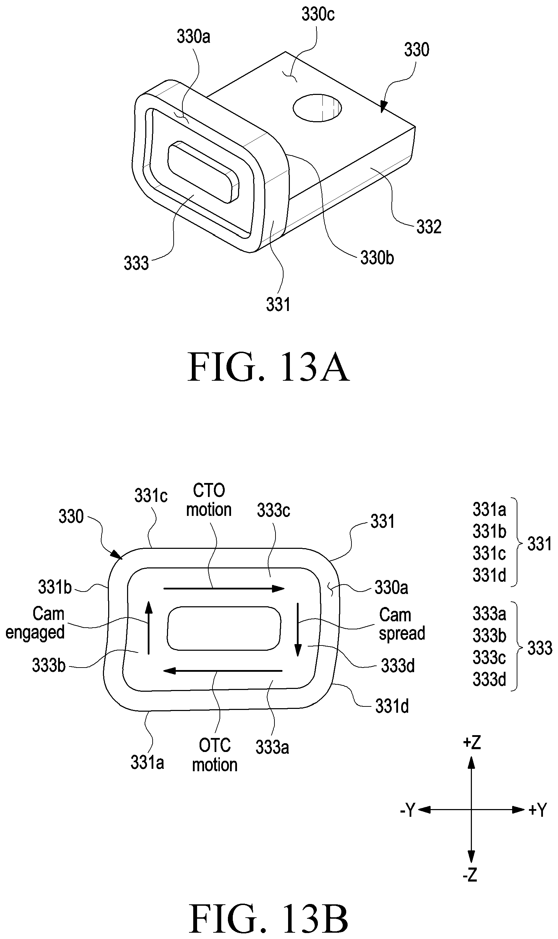

In the disclosure, the flex section in which the free stop function is implemented in OTC motion may be formed to be relatively longer and, in CTO motion, the flex section may be formed to be relatively shorter through the above-described dual-cam arrangement structure and independent behavior (operation mechanism) of the above-described dual-cam arrangement structure and arm members (first arm member 310-1 and second arm member 310-2) interlocking to the dual-cam arrangement structure. According to an embodiment, the first arm member 310-1 including the first cam structure 312a and the second arm member 310-2 including the second cam structure 314a may be disposed on the front (e.g., the first surface 330a) and the rear (e.g., the second surface 330b) of the first guide member 330, respectively. The first member 310-1 and the second arm member 310-2 may rotate with respect to the first shaft 351 through the cam structures 312a and 314a on one side, but the first body portion 311, the first protrusion 312b, and the second body portion 313 and the second protrusion 314b may move in different operation mechanisms (e.g., first movement path and second movement path) in the front (e.g., the first surface 330a) and the rear (e.g., the second surface 330b) of the first guide member 330. The different operation mechanisms (e.g., the first movement path and the second movement path) are described in more detail with reference to FIG. 13A.

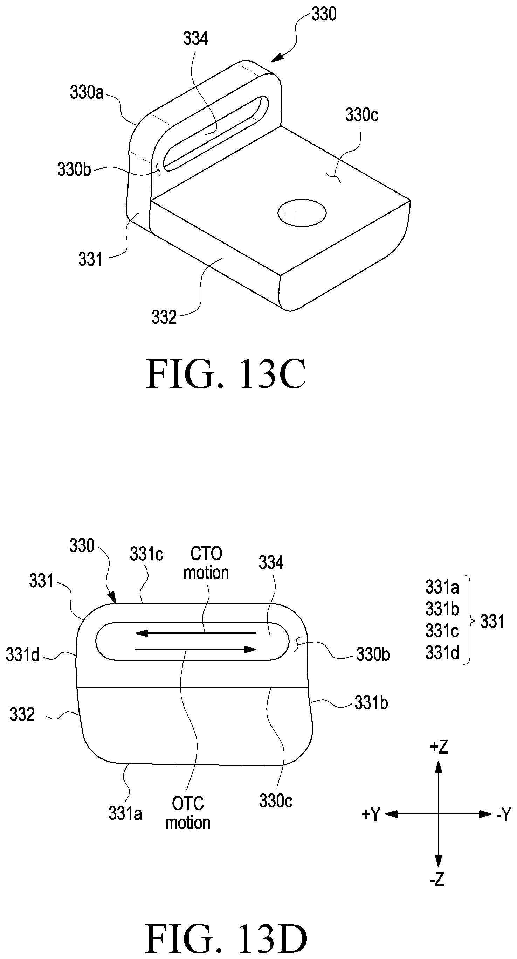

FIG. 13A is a perspective view illustrating a guide member according to an embodiment of the disclosure. FIG. 13B is a front view illustrating a guide member according to an embodiment of the disclosure. FIG. 13C is a perspective view illustrating a guide member according to an embodiment of the disclosure. FIG. 13D is a rear view illustrating a guide member according to an embodiment of the disclosure.

Referring to FIGS. 13A to 13D, the first guide member 330 may include a first vertical plate 331 including a first surface 330a and a second surface 330b, and a first horizontal plate 332 including a first base surface 330c perpendicular to the first surface 330a and the second surface 330b. The first horizontal plate 332 may be coupled to one surface (e.g., the rear surface 210b) of the first rotating member 210. In a state in which the first horizontal plate 332 is coupled to one surface of the first rotating member 210, a first arm member 310-1 and a second arm member 310-2 may be disposed in front and rear of the first vertical plate 331.

The first surface 330a of the first vertical plate 331 may face in a first direction (+X direction), and the second surface 330b may include a second direction (-X direction). A first rail 333 may be formed on the first surface 330a of the first vertical plate 331, and a second rail 334 may be formed on the second surface 330b. According to an embodiment, the first rail 333 may be formed in a substantially rectangular loop shape. According to an embodiment, the second rail 334 may be formed in a shape elongated in the length direction of the electronic device. Considering the shape of the rail, the first rail 333 may be referred to as an 'O rail' and/or a 'rectangular rail', and the second rail 334 may be referred to as an 'I rail' and/or a 'linear rail".

Referring to FIG. 13B, the first rail 333 may include a first section 333a positioned close to the rear surface of the electronic device, a second section 333b positioned close to the hinge portion of the electronic device, a third section 333c positioned close to the front surface of the electronic device, and a fourth section 333d positioned close to the side surface of the electronic device. The first section 333a may be formed long along the surface 331a facing the rear surface of the electronic device from the first vertical plate 331, and the second section 333b may be formed along the surface 331b facing the hinge portion of the electronic device from the first vertical plate 331. The third section 333c may be formed long along the surface 331c facing the front surface of the electronic device from the first vertical plate 331, and the fourth section 333d may be formed along the surface 331d facing the side surface of the electronic device from the first vertical plate 331. In this case, the second section 333b may be formed to be concave corresponding to the shape of the surface 331c facing the hinge portion of the electronic device of the first vertical plate 331, and the fourth section 333d may be formed to be convex corresponding to the surface facing the side surface of the electronic device in the first vertical plate 331. According to an embodiment, the first section 333a may provide a path where the first protrusion 312b of the first arm member 310-1 moves in the OTC motion of the electronic device, and the third section 333c may provide a path where the first protrusion 312b of the first arm member 310-1 moves in the CTO motion of the electronic device. As is described below, according to an embodiment, the second section 333b may provide a path where the first protrusion 312b of the first arm member 310-1 moves when the first cam structure 312a and the second cam structure 314a overlap each other (cam overlapped or cam engaged), and the fourth section 333d may provide a path where the first protrusion 312b of the first arm member 310-1 moves when the first cam structure 312a and the second cam structure 314a are spread from each other (cam spread). The first to fourth sections 333a to 333d may provide a first movement path in a loop shape (or a rectangular shape).

Referring to FIG. 13D, the second rail 334 may provide a second movement path where the second protrusion 314b of the second arm member 310-2 moves. According to an embodiment, the second rail 334 may provide a path where the second protrusion 314b of the second arm member 310-2 moves in the OTC motion or the CTO motion of the electronic device. The second rail 334 may be formed at a position corresponding to the third section 333c when the second rail 334 is projected onto the first surface 330a of the vertical plate 331.

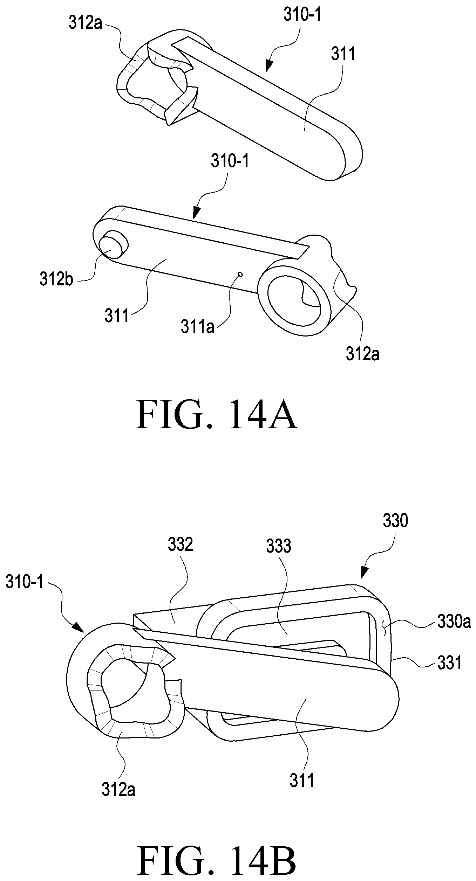

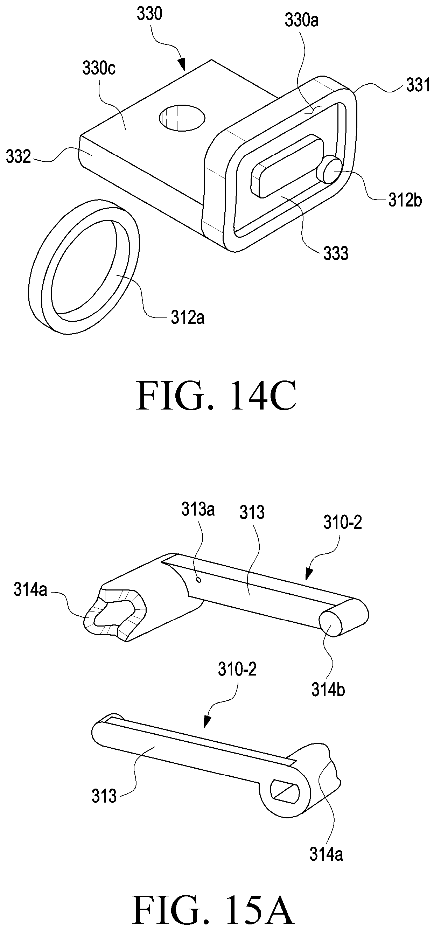

FIG. 14A is a perspective view illustrating a first arm member according to an embodiment of the disclosure. FIG. 14B is a perspective view illustrating a state in which a first arm member is coupled to a guide member according to an embodiment of the disclosure. FIG. 14C is a perspective view illustrating a state in which a first protrusion of a first arm member is disposed on a first rail of a guide member according to an embodiment of the disclosure.

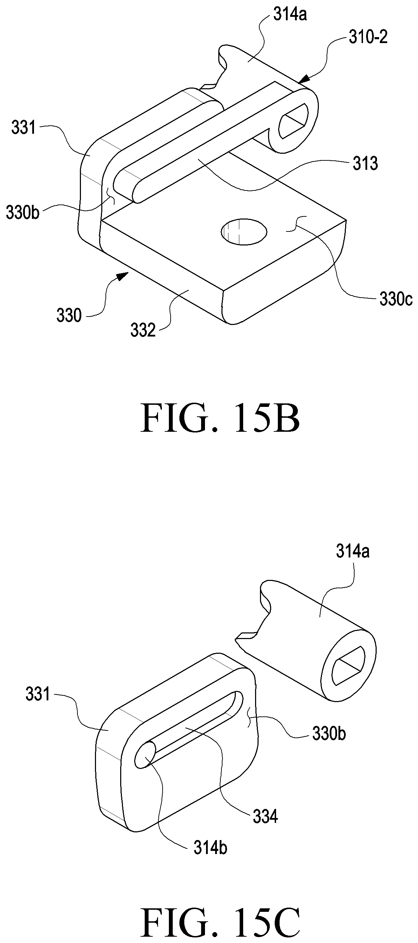

FIG. 15A is a perspective view illustrating a second arm member according to an embodiment of the disclosure. FIG. 15B is a perspective view illustrating a state in which a second arm member is coupled to a guide member according to an embodiment of the disclosure. FIG. 15C is a perspective view illustrating a state in which a second protrusion of a second arm member is disposed on a second rail of a guide member according to an embodiment of the disclosure.

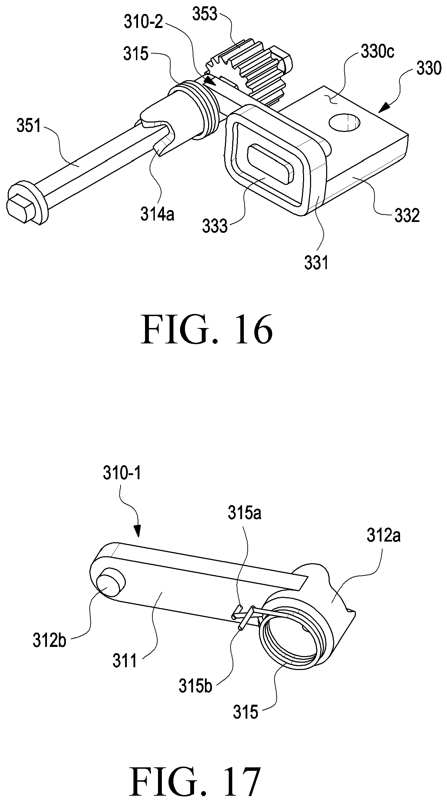

FIG. 16 is a perspective view illustrating a state in which a second arm member is connected to a first shaft according to an embodiment of the disclosure.

Referring to FIGS. 14A to 16 together, the first cam structure 312a of the first arm member 310-1 may have a hollow portion with a circular cross section formed therein. The second cam structure 314a of the second arm member 310-2 may be received in the hollow portion. Therefore, the diameter of the first cam structure 312a may be larger than the diameter of the second cam structure 314a.

The thickness of the first body portion 311 of the first arm member 310-1 and the thickness of the second body portion 313 of the second arm member 310-2 are shown to be slightly different from each other, referring to FIGS. 14A to 16, but are not necessarily limited thereto. According to an embodiment, the length of the first body portion 311 of the first arm member 310-1 may be substantially the same as the length of the second body portion 313 of the second arm member 310-2. In order to secure rigidity of the hinge module 180, there may be some differences in thickness or length between the first body portion 311 and the second body portion 313 in design. However, even in this case, the length from the first cam structure 312a of the first arm member 310-1 to the first protrusion 312b and the length from the second cam structure 314a of the second arm member 310-2 to the second protrusion 314b may be substantially the same. The first shaft 351 axially coupled to the first gear 353 may be fixedly disposed in the hollow portion formed in the second cam structure 314a, and thus the second arm member 310-2 may rotate according to the rotation of the first shaft 351. When the second arm member 310-02 rotates, the second protrusion 314b may press the vertical plate 331 on the second rail 334 of the first guide member 330 to rotate the first guide member 330. Simultaneously, the second protrusion 314b may slide along the second rail 334.

The above description of the first arm member 310-1 and the second arm member 310-2 may be applied to the description of the third arm member 320-1 and the fourth arm member 320-2.

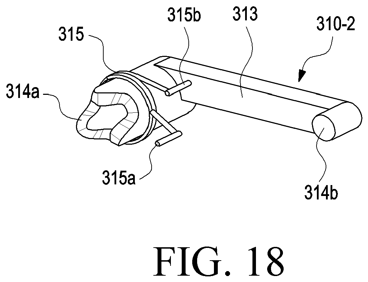

FIG. 17 is a perspective view illustrating a state in which a first elastic member is connected to a first arm member according to an embodiment of the disclosure. FIG. 18 is a perspective view illustrating a state in which a first elastic member is connected to a second arm member according to an embodiment of the disclosure.

One end 315a of the first elastic member 315 may be connected to the body portion 311 of the first arm member 310-1, and the other end 315b may be connected to the body portion 313 of the second arm member 310-2. The first elastic member 315 may correspond to a torsional spring, and may provide a force for spreading the first cam structure 312a of the first arm member 310-1 and the second cam structure 314a of the second arm member 310-2 from each other.

Referring to FIGS. 17 and 18 together with FIGS. 14A and 15A, one end 315a of the first elastic member 315 may be inserted into and fastened to the connection recess 311a of the body portion 311 of the first arm member 310-1, and the other end of the first elastic member 315 may be inserted into and fastened to the connection recess 313a of the body portion 313 of the second arm member 310-2.

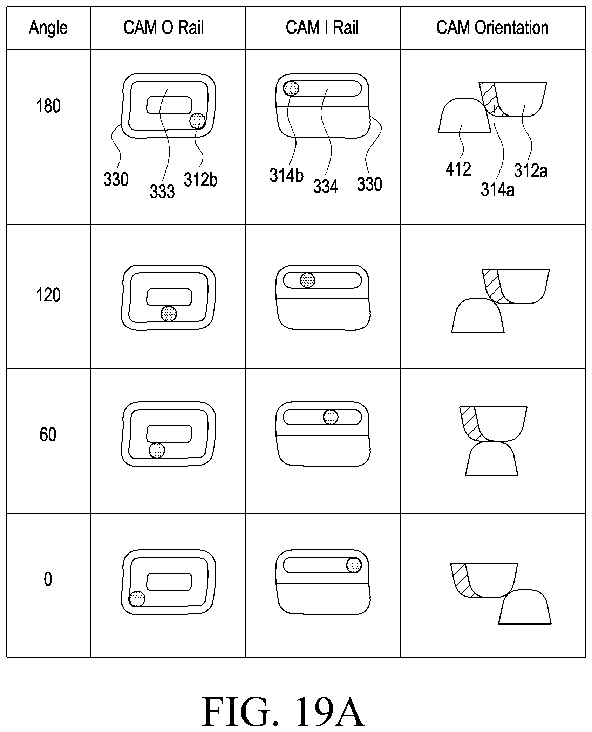

Hereinafter, the behavior of the first arm member 310-1 and the second arm member 310-2 corresponding to the angle between the first housing 110 and the second housing 120 is described in detail with reference to embodiments of FIGS. 19A to 22C.

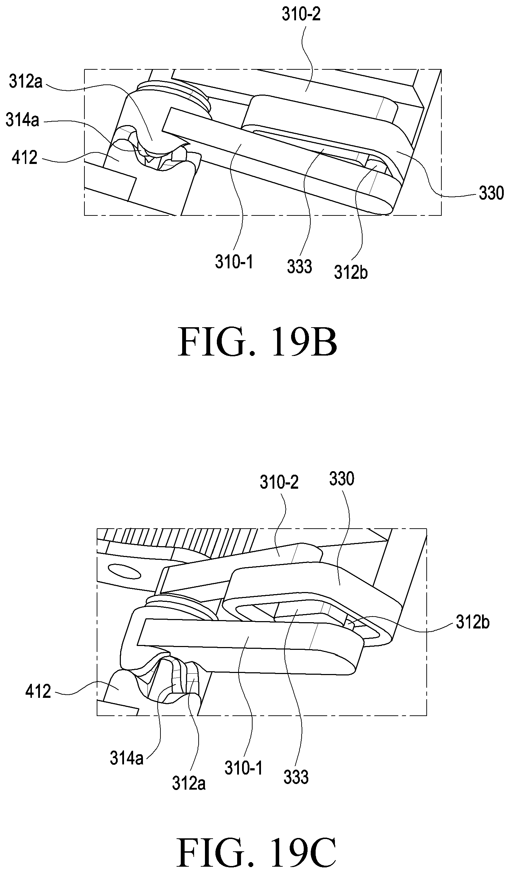

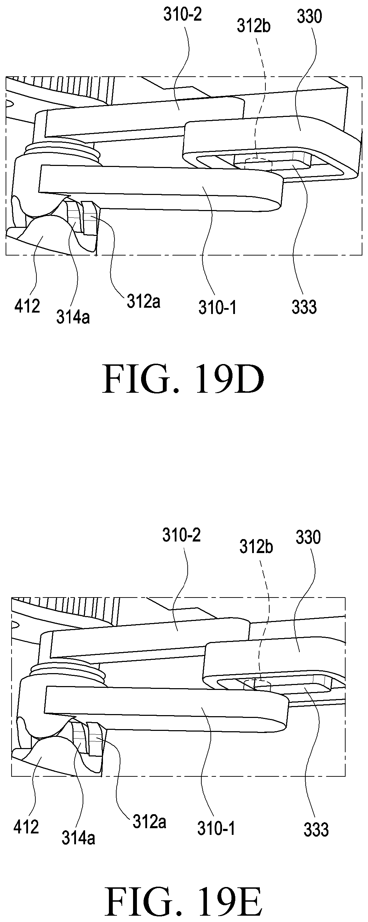

FIG. 19A is a view illustrating behavior of a first protrusion disposed on a first rail and a second protrusion disposed on a second rail and behavior of a first cam structure, a second cam structure, and a third cam structure at each of various angles between a first housing and a second housing according to an embodiment of the disclosure. FIG. 19B is a view illustrating behavior of an interlocking structure and a fixed structure when an angle between a first housing and a second housing is about 180 degrees according to an embodiment of the disclosure. FIG. 19C is a view illustrating behavior of an interlocking structure and a fixed structure when an angle between a first housing and a second housing is about 120 degrees according to an embodiment of the disclosure. FIG. 19D is a view illustrating behavior of an interlocking structure and a fixed structure when an angle between a first housing and a second housing is about 60 degrees according to an embodiment of the disclosure. FIG. 19E is a view illustrating behavior of an interlocking structure and a fixed structure when an angle between a first housing and a second housing is about 0 degrees according to an embodiment of the disclosure. The embodiment shown in FIGS. 19A to 19E may illustrate an angle change with respect to one interlocking structure 300 of the pair of interlocking structures 300 included in the hinge module 180. Since the third arm member 320-1 and the fourth arm member 320-2 may move symmetrically together with the first arm member 310-1 and the second arm member 310-2 in the foldable electronic device 110 of the disclosure, when the angle according to the behavior of the first arm member 310-1 and the second arm member 310-2 is, e.g., about 90 degrees, the angle between the first housing and the second housing may form about 180 degrees.

When the angle between the first housing 110 and the second housing 120 is 180 degrees, it may mean that the foldable electronic device 100 is in an unfolded state. Referring to the embodiments of FIGS. 19A and 19B, in the unfolded state of the foldable electronic device 100, the first arm member 310-1 and the second arm member 310-2 may start driving in an opened state (OTC motion start). This may mean a state in which the first cam structure 312a and the second cam structure 314a are spread from each other, i.e., a state in which a long flex section is secured. Referring to FIGS. 19A to 19D, as the first housing 110 and the second housing 120 are gradually narrowed, i.e., as the close operation proceeds, the first protrusion 312b positioned at the end portion of the first arm member 310-1 moves linearly on the first section 333a of the first rail 333, and the second protrusion 314b positioned at the end portion of the second arm member 310-2 moves linearly on the second rail 334. In this case, if the first protrusion 312b moves linearly, the second protrusion 314b may also move as much as the first protrusion 312b moves. In this case, the opened angle between the first arm member 310-1 and the second arm member 310-2 (or the first cam structure 312a and the second cam structure 314a) may remain constant. In this case, since it is in the state in which the first cam structure 312a and the second cam structure 314a are spread from each other, i.e., a state in which a long flex section is secured, a long section in which the free stop function is implemented may be formed. Referring to FIGS. 19A to 19E, the angle between the first housing 110 and the second housing 120 may be gradually decreased, and as shown in FIG. 19E, when the angle is 0, the first housing 110 and the second housing 120 may be folded to face each other.

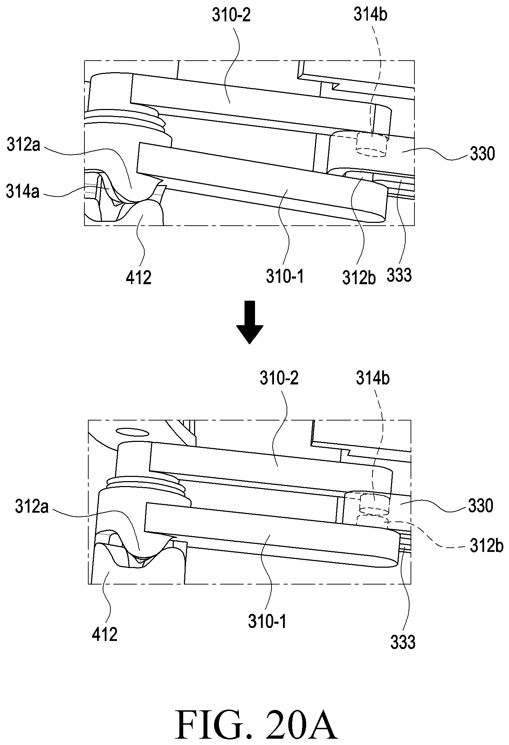

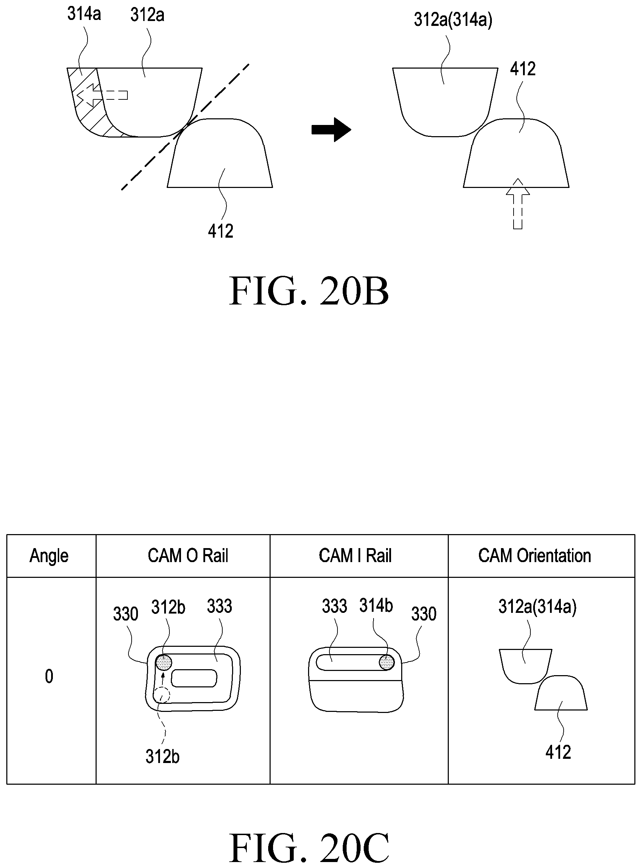

FIG. 20A is a view illustrating behavior of an interlocking structure and a fixed structure when an angle between a first housing and a second housing is about 0 degrees according to an embodiment of the disclosure. FIG. 20B is a view illustrating behavior of a first cam structure, a second cam structure, and a third cam structure when an angle between a first housing and a second housing is about 0 degrees according to an embodiment of the disclosure. FIG. 20C is a view illustrating behavior of a first protrusion 312b of a first arm member 310-1 when an angle between a first housing and a second housing is about 0 degrees according to an embodiment of the disclosure. Referring to FIGS. 20A to 20C, when the first housing and the second housing reach the folded state in which they face each other, both the first protrusion 312b that has moved on the first section 333a of the first rail 333 and the second protrusion 314b that has moved on the second rail 334 may reach the end portions of the respective rails. In this case, the first protrusion 312b of the first arm member 310-1 may obtain a degree of freedom to move on the second section 333b of the first rail 333. Referring to FIG. 20B, at this time, the spring force transferred as the elastic members 421 and 422 support the fixing cam member 410 pushes the fifth cam structure 412, and the fifth cam structure 412 of the fixing cam member 410 moves a predetermined distance in the first direction (+X direction) so that the first cam structure 312a is rotated to overlap (or engaged with) the second cam structure 314a. According to an embodiment, as the first cam structure 312a rotates, the first protrusion 312b positioned at the other end of the first arm member 310-1 may move in a vertical direction from the end point of the first section 333a. When the first protrusion 312b moves from the end point of the first section 333a toward the second section 333b, the angle between the first arm member 310-1 and the second arm member 310-2 is decreased, and if the first protrusion 312b reaches the end point of the second section 333b, when the first arm member 310-1 is viewed in the second direction (-X direction), the angle between the first arm member 310-1 and the second arm member 310-2 may form 0 degrees and overlap each other in parallel. In this case, the first cam structure 312a, which was disposed to be misaligned with the second cam structure 314a, may move toward the second cam structure 314a, so that the first cam structure 312a and the second cam structure 314a may overlap each other (or engaged with each other).

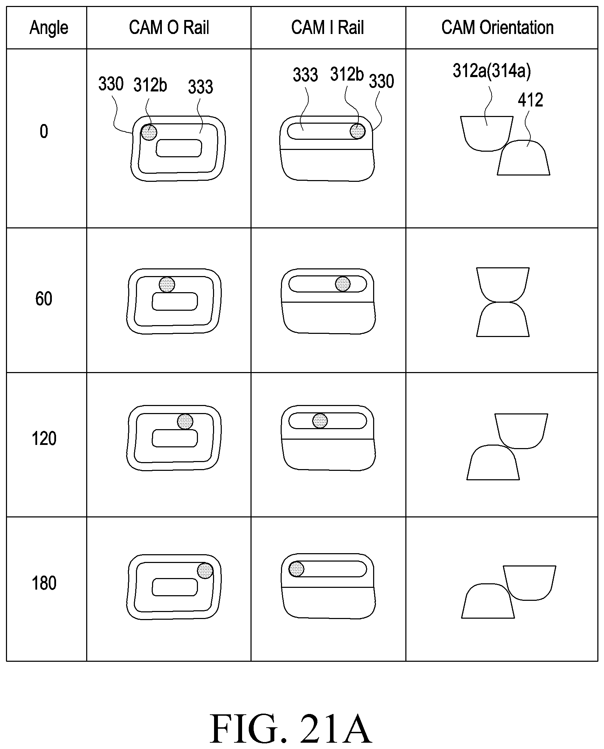

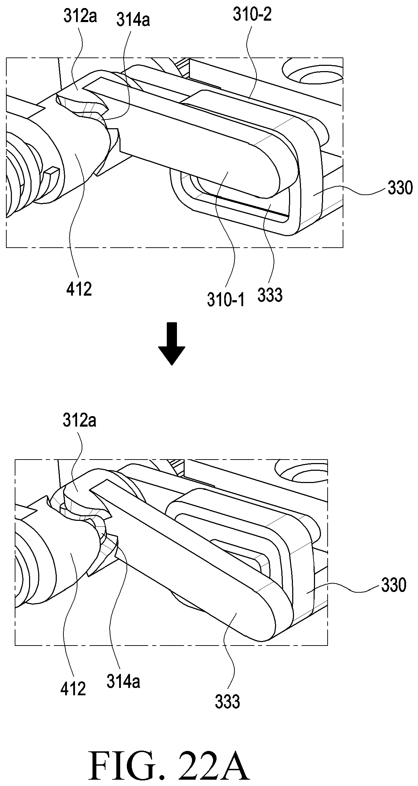

When the operation from the embodiment shown in FIG. 19B through FIGS. 19C, 19D, and 19E to the embodiment shown in FIG. 20A, i.e., the close operation, is completed, the first protrusion 312b of the first arm member 310-1 may be positioned on the third section 333c of the first rail 333, and the two cam structures 312a and 314 may overlap (or engaged with) each other to have a reduced flex section. Hereinafter, after the flex section is reduced through the embodiments of FIGS. 21A to 22C, a method of driving the cam when the open operation is started (CTO motion start) may be described.

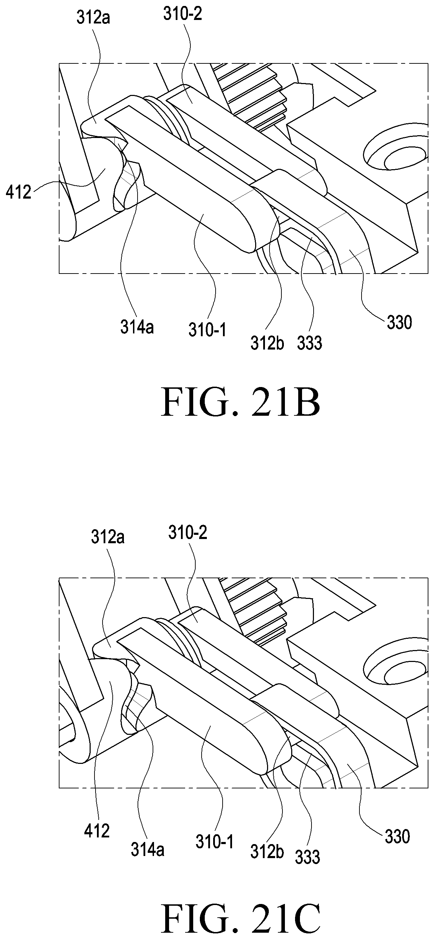

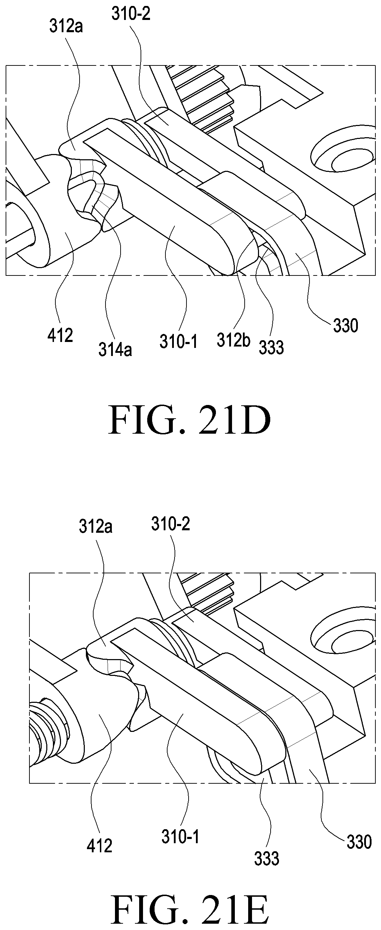

FIG. 21A is a view illustrating behavior of a first protrusion disposed on a first rail and a second protrusion disposed on a second rail and behavior of a first cam structure, a second cam structure, and a third cam structure at each of various angles between a first housing and a second housing according to an embodiment of the disclosure. FIG. 21B is a view illustrating behavior of an interlocking structure and a fixed structure when an angle between a first housing and a second housing is about 0 degrees according to an embodiment of the disclosure. FIG. 21C is a view illustrating behavior of an interlocking structure and a fixed structure when an angle between a first housing and a second housing is about 60 degrees according to an embodiment of the disclosure. FIG. 21D is a view illustrating behavior of an interlocking structure and a fixed structure when an angle between a first housing and a second housing is about 120 degrees according to an embodiment of the disclosure. FIG. 21E is a view illustrating behavior of an interlocking structure and a fixed structure when an angle between a first housing and a second housing is about 180 degrees according to an embodiment of the disclosure.

When the angle between the first housing and the second housing is 0 degrees, it may mean that the foldable electronic device is in a folded state. Referring to the embodiments of FIGS. 21A and 21B, in the folded state of the foldable electronic device, the first arm member 310-1 and the second arm member 310-2 may start to be driven in an overlapping state. This may mean a state in which the first cam structure 312a and the second cam structure 314a overlap each other (or engaged with), i.e., a state in which a short flex section is secured. Referring to FIGS. 21A to 21D, as the first housing and the second housing are gradually spread, i.e., as the open operation proceeds, the first protrusion 312b positioned at the end portion of the first arm member 310-1 moves linearly on the third section 333c of the first rail 333, and the second protrusion 314b positioned at the end portion of the second arm member 310-2 moves linearly on the second rail 334. In this case, if the first protrusion 312b moves linearly, the second protrusion 314b may also move as much as the first protrusion 312b moves. In this case, the first arm member 310-1 and the second arm member 310-2 (or the first cam structure 312a and the second cam structure 314a) may remain overlapping in parallel with each other. In this case, since it is in the state in which the first cam structure 312a and the second cam structure 314a overlap each other, i.e., a state in which a short flex section is secured, a short section in which the free stop function is implemented may be formed. In this case, it may be easy for the user to open the electronic device with only one hand. In other words, one-hand open may be possible. Referring to FIGS. 21A to 21E, the angle between the first housing and the second housing may be gradually increased, and as shown in FIG. 21E, when the angle is about 180, the first housing and the second housing may become the unfolded state in which they face in the same direction.

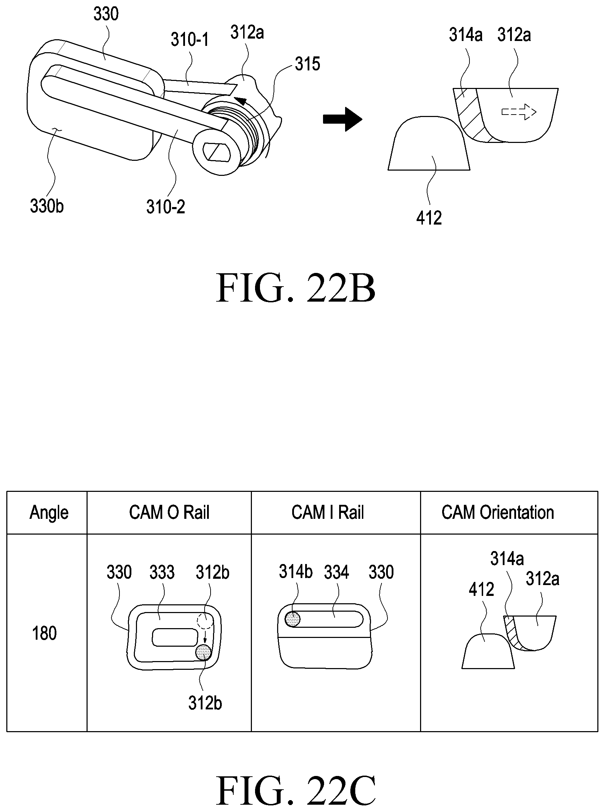

FIG. 22A is a view illustrating behavior of an interlocking structure and a fixed structure when an angle between a first housing and a second housing is about 180 degrees according to an embodiment of the disclosure. FIG. 22B is a view illustrating behavior of a first protrusion 312b of a first arm member 310-1 and behavior of a first cam structure, a second cam structure, and a third cam structure when an angle between a first housing and a second housing is about 180 degrees according to an embodiment of the disclosure. FIG. 22C is a view illustrating behavior of a first protrusion 312b of a first arm member 310-1 when an angle between a first housing and a second housing is about 180 degrees according to an embodiment of the disclosure.

Referring to FIGS. 22A to 22C, when the first housing and the second housing reach the unfolded state in which they face in the same direction, both the first protrusion 312b that has moved on the third section 333c of the first rail 333 and the second protrusion 314b that has moved on the second rail 334 may reach the end portions of the respective rails. In this case, the first protrusion 312b of the first arm member 310-1 may obtain a degree of freedom to move on the fourth section 333d of the first rail 333. Referring to FIG. 22B, in this case, the first cam structure 312a is rotated by the torsional force of the elastic member 315 to be misaligned with the second cam structure 314a. Accordingly, the first protrusion 312b may move in the vertical direction from the end point of the third section 333c. While the first protrusion 312b moves on the fourth section 333d, an elastic force applied by the elastic member 315 may open the first arm member 310-1 and the second arm member 310-2 so that the first cam structure 312a and the second cam structure 314a may be misaligned from each other. In this case, as the first cam structure 312a and the second cam structure 314a are disposed to be misaligned with each other, the flex section is increased.

When the first protrusion 312b moves from the end point of the third section 333c toward the fourth section 333d, the angle between the first arm member 310-1 and the second arm member 310-2 is increased, and if the first protrusion 312b reaches the end point of the fourth section 333d (or the initial point of the first section 333a), the angle between the first arm member 310-1 and the second arm member 310-2 may be spread as much as possible when the first arm member 310-1 is viewed in the second direction (-X direction). Further, the first arm member 310-1 and the second arm member 310-2 may remain in the state of being misaligned with each other. In this case, since it is in the state in which the first cam structure 312a and the second cam structure 314a are misaligned with each other, i.e., a state in which a long flex section is secured, a long section in which the free stop function is implemented may be formed.

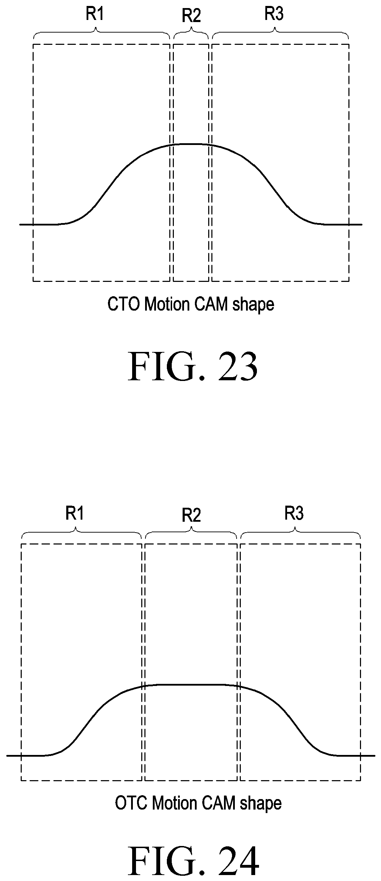

FIG. 23 is a view illustrating a cam profile in a CTO motion according to an embodiment of the disclosure. FIG. 24 is a view illustrating a cam profile in an OTC motion according to an embodiment of the disclosure.

According to the disclosure, it may be possible to adjust the flex section of the cam profile.

Referring to FIGS. 23 and 24, in the disclosure, in the CTO motion of the foldable electronic device, i.e., when gradually progressing from the close state to the open state, the cam profile may have a small flex section for implementing a free stop function. Therefore, it may be easy for the user to open the electronic device with only one hand. In the OTC motion of the foldable electronic device, i.e., when the foldable electronic device gradually progresses from the open state to the close state, the cam profile may have a relatively long flex section.

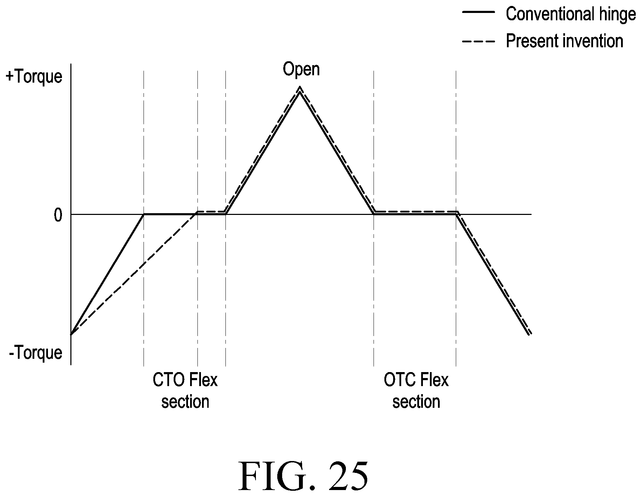

FIG. 25 is a graph illustrating cam torque for each of various sections according to an embodiment of the disclosure.

Referring to FIG. 25, in the disclosure (dashed line), a structure in which the cams are disposed inside and outside to vary the flex section is provided. By disposing the cams (first cam structure and second cam structure) of the same shape inside and outside, it is possible to implement a relatively short flex section as the two cam structures are engaged with each other in the CTO motion and to implement a relatively long flex section as the two cam structures are misaligned in the OTC motion. According to an embodiment, as compared to a conventionally known hinge module (or hinge structure), in the disclosure, the electronic device may be configured to be opened with less force in the CTO motion (or CTO flex) section than in the OTC motion (or OTC flex) section.

As described above, according to various embodiments of the disclosure, it is possible to allow the user to open the foldable electronic device with one hand, so-called one-hand open operation, while maintaining a free stop function by providing a hinge module in which the flex section is variable. Further, it is possible to increase user convenience by allowing the foldable electronic device to be opened with less effort.

According to an embodiment of the disclosure, a foldable electronic device 100 may be provided. The foldable electronic device 100 may include a first housing 110, a second housing 120, a hinge module 180 coupled to the first housing and the second housing such that the first housing and the second housing are capable of rotating, and a display 130 formed to be varied in response to a relative motion of the second housing with respect to the first housing. The hinge module 180 may include a first rotating member 210 connected to the first housing; a second rotating member 220 connected to the second housing; a first arm member 310-1 including a first cam structure 312a formed at one end and a first protrusion 312b formed at another end; a second arm member 310-2 including a second cam structure 314a formed at one end and a second protrusion 314b formed at another end; a third arm member 320-1 including a third cam structure 322a formed at one end and a third protrusion 322b formed at another end; a fourth arm member 320-2 including a fourth cam structure 324a formed at one end and a fourth protrusion 324b formed at another end; a first guide member 330 connected to the first rotating member 210 and including a first rail 333 formed on a first surface 330a to receive the first protrusion 312b of the first arm member 310-1 and a second rail 334 formed on a second surface 330b to receive the second protrusion 314b of the second arm member 310-2; and a second guide member 340 connected to the second rotating member 220 and including a third rail 343 formed on a third surface 340a to receive the third protrusion 322b of the third arm member 320-1 and a fourth rail 344 formed on a fourth surface 340b to receive the fourth protrusion 324b of the fourth arm member 320-2.

According to an embodiment of the disclosure, a foldable electronic device 100 may be provided. The foldable electronic device may include a first housing 110, a second housing 120, a hinge module 180 rotatably coupling the first housing and the second housing, and a flexible display 130. The hinge module 180 may include a first arm member 310-1 including the first cam structure 312a; a second arm member 310-2 including the second cam structure 312b; and a fixing cam member 410 including a third cam structure 412 engaged with the first cam structure 312a and the second cam structure 312b. The foldable electronic device may be changed in angle between a folded state and an unfolded state according to an angle between the first housing and the second housing. The hinge module may be formed so that a relative position of the first cam structure with respect to the second cam structure increases when the foldable electronic device changes from the unfolded state to the folded state, and a relative position of the first cam structure with respect to the second cam structure, to be engaged with the first cam structure, decreases when the foldable electronic device changes form the folded state to the unfolded state.

According to an embodiment of the disclosure, an electronic device 100 including a hinge module may be provided. The electronic device may include a rotating member 210; 220 connected to the housing 110; 120; a first arm member 310-1; 320-1 including a first cam structure 312a; 322a at one end and a first protrusion 312b; 322b at another end; a second arm member 310-2; 320-2 including a second cam structure 314a, 324a at one end and a second protrusion 314b; 324b at another end; and a guide member connected to the rotating member and including a first rail 333 formed on a first surface 330a to receive the first protrusion of the first arm member and a second rail 334 formed on a second surface 330b to receive the second protrusion of the second arm member.

It is apparent to one of ordinary skill in the art that an electronic device including a hinge module as described above are not limited to the above-described embodiments and those shown in the drawings, and various changes, modifications, or alterations may be made thereto without departing from the scope of the disclosure.

## Claims

1. A foldable electronic device (100), comprising:
a first housing (110);
a second housing (120);
a hinge module (180) coupled to the first housing and the second housing, such that the first housing and the second housing are capable of rotating about a folding axis (A); and
a flexible display (130), wherein the hinge module (180) includes:
a first rotating member (210) connected to the first housing;
a second rotating member (220) connected to the second housing;
a first arm member (310-1) including a first cam structure (312a) formed at one end and a first protrusion (312b) formed at another end;
a second arm member (310-2) including a second cam structure (314a) formed at one end and a second protrusion (314b) formed at another end;
a third arm member (320-1) including a third cam structure (322a) formed at one end and a third protrusion (322b) formed at another end;
a fourth arm member (320-2) including a fourth cam structure (324a) formed at one end and a fourth protrusion (324b) formed at another end;
a first guide member (330) connected to the first rotating member (210) and including a first rail (333) formed on a first surface (330a) to receive the first protrusion (312b) of the first arm member (310-1) and a second rail (334) formed on a second surface (330b) to receive the second protrusion (314b) of the second arm member (310-2); and
a second guide member (340) connected to the second rotating member (220) and including a third rail (343) formed on a third surface (340a) to receive the third protrusion (322b) of the third arm member (320-1) and a fourth rail (344) formed on a fourth surface (340b) to receive the fourth protrusion (324b) of the fourth arm member (320-2).

2. The foldable electronic device of claim 1, wherein in response to a relative motion of the second housing with respect to the first housing, the first protrusion (312b) of the first arm member (310-1) is configured to move along a first movement path on the first rail (333), and the third protrusion (322b) of the third arm member (320-1) is configured to move a third movement path, which is symmetrical with the first movement path with respect to the folding axis (A), on the third rail (343), and
wherein the second protrusion (314b) of the second arm member (310-2) is configured to move along a second movement path on the second rail (334), and the fourth protrusion (324b) of the fourth arm member (320-2) is configured to move along a fourth movement path, which is symmetrical with the first movement path with respect to the folding axis (A), on the fourth rail (344).

3. The foldable electronic device of claim 1, further comprising:
a first elastic member (315) disposed between the first arm member and the second arm member to elastically connect the first arm member and the second arm member; and
a second elastic member (325) disposed between the third arm member and the fourth arm member to elastically connect the third arm member and the fourth arm member.

4. The foldable electronic device of any one of claims 1 to 3, further comprising:
a gear member (350);
a first shaft (351) configured to form a first interlocking axis (Rx1);
a second shaft (352) configured to form a second interlocking axis (Rx2);
a first gear (353) positioned on the first interlocking axis; and
a second gear (354) positioned on the second interlocking axis.

5. The foldable electronic device of claim 4, further comprising:
an interlocking gear (355) configured to interlock the first gear and the second gear,
wherein the interlocking gear (355) includes a third gear (356) forming a first rotational axis (Ax1) for rotating the first housing and a fourth gear (357) configured to be engaged with the third gear and forming a second rotational axis (Ax2) for rotating the second housing.

6. The foldable electronic device of any one of claims 1 to 5, further comprising a fixing bracket (360) on which the first rotating member and the second rotating member are coupled to be rotatable about the first rotational axis and the second rotational axis, respectively.

7. The foldable electronic device of claim 6, wherein the fixing bracket includes a first guide rail (360a) guiding the first rotating member to be rotatable with respect to the first rotational axis and a second guide rail guiding the second rotating member to be rotatable with respect to the second rotational axis.

8. The foldable electronic device of any one of claims 1 to 7, wherein the first guide member includes a first vertical plate including the first surface and the second surface and a first horizontal plate including a first base surface perpendicular to the first surface and the second surface, and
wherein the second guide member includes a second vertical plate including the third surface and the fourth surface and a second horizontal plate including a second base surface perpendicular to the third surface and the fourth surface.

9. The foldable electronic device of claim 8, wherein the first rail formed on the first surface of the first guide member has a loop shape, and the third rail formed on the third surface of the second guide member has a loop shape.

10. The foldable electronic device of claim 9, wherein the first rail includes a first section (333a) configured to be disposed close to a rear surface of the electronic device, a second section (333b) configured to be disposed close to a hinge portion of the electronic device, a third section (333c) configured to be disposed close to a front surface of the electronic device, and a fourth section (333d) configured to be disposed close to a side surface of the electronic device, and
wherein the second section is concave, and the fourth section is convex.

11. The foldable electronic device of claim 9 or 10, wherein the first protrusion of the first arm member is configured to move along the first rail in response to a relative motion of the first housing with respect to the second housing, and
wherein the third protrusion of the third arm member is configured to move along the third rail in response to a relative motion of the first housing with respect to the second housing.

12. The foldable electronic device of claim 9 or 10, wherein the second protrusion of the second arm member is configured to move along the second rail in response to a relative motion of the first housing with respect to the second housing, and the fourth protrusion of the fourth arm member is configured to move along the fourth rail in response to a relative motion of the first housing with respect to the second housing.

13. The foldable electronic device of claim 10, wherein when the first vertical plate of the first guide member is viewed in a direction parallel to the first rotational axis or the second rotational axis, the second rail formed on the second surface is formed at substantially the same position as the third section of the first rail.

14. The foldable electronic device of any one of claims 1 to 13, wherein when the first arm member is coupled to the second arm member, the first cam structure of the first arm member is configured to receive the second cam structure of the second arm member therein.

15. The foldable electronic device of any one of claims 1 to 14, further comprising a fixing cam member (410) including a fifth cam structure (412) configured to be engaged with the first cam structure (312a) and the second cam structure (312b),
wherein a position of the hinge module is fixed at a flex section as long as no external force acts when the first cam structure and the second cam structure are engaged with the fifth cam structure, and wherein the flex section is configured to be variable based on a relative motion of the first housing with respect to the second housing.
